# EUROPEAN PATENT APPLICATION

(11) **EP 4 800 680 A2**
(43) Date of publication of application: **02.09.2026**
(21) Application number: 26157851.2
(22) Date of filing: 11.02.2026
(51) Int. Cl.: G09G 3/32

(54) **DISPLAY APPARATUS AND ELECTRONIC APPARATUS INCLUDING THE SAME**

(30) Priority: 11.02.2025 KR 20250017567; 21.02.2025 KR 20250023162; 12.09.2025 KR 20250131130
(71) Applicant: Samsung Display Co., Ltd., Yongin-si, Gyeonggi-do 17113 (KR)
(72) Inventor: PARK, Buyoung, 17113 Yongin-si (KR); KIM, Donghyun, 17113 Yongin-si (KR); CHEON, Soohong, 17113 Yongin-si (KR)
(74) Representative: Marks & Clerk LLP

(57) **Abstract**

A display apparatus may include a first sub-pixel circuit unit including a first sub-pixel circuit, a second sub-pixel circuit, and a third sub-pixel circuit that may be arranged in a first direction, a plurality of light-emitting diodes electrically connected to the first sub-pixel circuit, the second sub-pixel circuit, and the third sub-pixel circuit, respectively, and a driving voltage line electrically connected to at least one of the first sub-pixel circuit, the second sub-pixel circuit, or the third sub-pixel circuit to transmit a driving voltage. The driving voltage line may include a lower driving voltage line extending in a second direction crossing the first direction, and an upper driving voltage line on the lower driving voltage line in a thickness direction of the display apparatus, the upper driving voltage being electrically connected to the lower driving voltage line, and extending in the second direction.

## Description

### BACKGROUND

### 1. Field

One or more embodiments relate to a display apparatus and an electronic apparatus including the same.

### 2. Description of Related Art

Recently, the uses of display apparatuses and electronic apparatuses including the display apparatuses have become more diversified. In addition, as the range of use of display apparatuses expands, the demand for high-resolution display apparatuses has increased. To manufacture high-resolution display apparatuses, it may be necessary to arrange electronic components of various configurations in a narrow area.

### SUMMARY

One or more embodiments include a display apparatus with improved display quality and an electronic apparatus including the display apparatus. However, these objectives are examples, and the scope of the disclosure is not limited thereto.

Additional aspects will be set forth in part in the description which follows and, in part, will be apparent from the description, or may be learned by practice of the presented embodiments of the disclosure.

In one or more embodiments, a display apparatus may include: a first sub-pixel circuit unit including a first sub-pixel circuit, a second sub-pixel circuit, and a third sub-pixel circuit that may be arranged in a first direction; a plurality of light-emitting diodes electrically connected to the first sub-pixel circuit, the second sub-pixel circuit, and the third sub-pixel circuit, respectively; and a driving voltage line electrically connected to at least one of the first sub-pixel circuit, the second sub-pixel circuit, or the third sub-pixel circuit to transmit a driving voltage, wherein the driving voltage line may include: a lower driving voltage line extending in a second direction crossing the first direction; and an upper driving voltage line on the lower driving voltage line in a thickness direction of the display apparatus, the upper driving voltage being electrically connected to the lower driving voltage line, and extending in the second direction.

The display apparatus may further include a common voltage line electrically connected to at least one of the plurality of light-emitting diodes to transmit a common voltage, wherein the common voltage line may include: a lower common voltage line extending in the second direction; and an upper common voltage line on the lower common voltage line in the thickness direction of the display apparatus, the upper common voltage line being electrically connected to the lower common voltage line, and extending in the second direction.

The lower driving voltage line and the lower common voltage line may be on a same layer, and the upper driving voltage line and the upper common voltage line may be on another same layer.

The display apparatus may include a data line electrically connected to at least one of the first sub-pixel circuit, the second sub-pixel circuit, or the third sub-pixel circuit to transmit a data signal, and extending in the second direction, wherein the data line may be on a same layer as the lower driving voltage line.

Each of the first sub-pixel circuit, the second sub-pixel circuit, and the third sub-pixel circuit may include: a first transistor electrically connected between one of the plurality of light-emitting diodes and the driving voltage line; a first node electrode connected to a gate electrode of the first transistor; and a second transistor connected between the data line and the first node electrode. The lower driving voltage line and the data line may be on the first node electrode in the thickness direction of the display apparatus.

The display apparatus may include a second sub-pixel circuit unit, a third sub-pixel circuit unit, and a fourth sub-pixel circuit unit, which may be arranged adjacent to the first sub-pixel circuit unit in the first direction and may be sequentially arranged in the first direction; a lower voltage line group including a plurality of lower voltage lines on the first to fourth sub-pixel circuit units and extending in the second direction; and an upper voltage line group including a plurality of upper voltage lines on the plurality of lower voltage lines and extending in the second direction, wherein the lower voltage line group and the upper voltage line group may be repeatedly arranged within a display area of the display apparatus.

The lower voltage line group may include: the lower driving voltage line; a lower common voltage line electrically connected to one of the plurality of light-emitting diodes to transmit a common voltage and extending in the second direction; a reference voltage line electrically connected to at least one of the first sub-pixel circuit, the second sub-pixel circuit, or the third sub-pixel circuit to transmit a reference voltage and extending in the second direction; and an initialization voltage line electrically connected to at least one of the first sub-pixel circuit, the second sub-pixel circuit, or the third sub-pixel circuit to transmit an initialization voltage and extending in the second direction.

Two lower driving voltage lines may be on two sub-pixel circuit units among the first sub-pixel circuit unit, the second sub-pixel circuit unit, the third sub-pixel circuit unit, and the fourth sub-pixel circuit unit.

The initialization voltage line may include: a first initialization voltage line configured to transmit the initialization voltage to the first sub-pixel circuit; a second initialization voltage line configured to transmit the initialization voltage to the second sub-pixel circuit; and a third initialization voltage line configured to transmit the initialization voltage to the third sub-pixel circuit. One first initialization voltage line, one second initialization voltage line, and one third initialization voltage line may be on two sub-pixel circuit units among the first sub-pixel circuit unit, the second sub-pixel circuit unit, the third sub-pixel circuit unit, and the fourth sub-pixel circuit unit.

One reference voltage line may be on the first sub-pixel circuit unit, the second sub-pixel circuit unit, the third sub-pixel circuit unit, and the fourth sub-pixel circuit unit, and one lower common voltage line may be on the first sub-pixel circuit unit, the second sub-pixel circuit unit, the third sub-pixel circuit unit, and the fourth sub-pixel circuit unit.

Each of the plurality of light-emitting diodes may include a pixel electrode, an opposite electrode, and an intermediate layer between the pixel electrode and the opposite electrode. The upper voltage line group may include: the upper driving voltage line; and an upper common voltage line electrically connected to the opposite electrode to transmit a common voltage to the opposite electrode and extending in the second direction.

The display apparatus may include an auxiliary electrode on a same layer as the pixel electrode, the auxiliary electrode being spaced apart from the pixel electrode and in contact with the opposite electrode, wherein the upper common voltage line may include: a first upper common voltage line in contact with the auxiliary electrode within the display area to transmit the common voltage to the opposite electrode; and a second upper common voltage line configured to transmit the common voltage to the opposite electrode within a peripheral area that surrounds the display area.

Seven upper driving voltage lines and seven second upper common voltage lines may be on the first sub-pixel circuit unit, the second sub-pixel circuit unit, the third sub-pixel circuit unit, and the fourth sub-pixel circuit unit, and two first upper common voltage lines may be on the first sub-pixel circuit unit, the second sub-pixel circuit unit, the third sub-pixel circuit unit, and the fourth sub-pixel circuit unit.

At least a portion of the upper driving voltage line has a mesh-shaped structure, and the upper driving voltage line may include: a first vertical portion extending in the second direction; a second vertical portion extending in the second direction; and a first horizontal portion extending in the first direction and connecting the first vertical portion to the second vertical portion.

In one or more embodiments, a display apparatus may include: a substrate; a first sub-pixel circuit on the substrate; a first light-emitting diode electrically connected to the first sub-pixel circuit; a plurality of voltage lines including a driving voltage line, an initialization voltage line, and a reference voltage line, which may be electrically connected to the first sub-pixel circuit; and a data line electrically connected to the first sub-pixel circuit to transmit a data signal, wherein the first sub-pixel circuit may include: a driving transistor connected between the driving voltage line and the first light-emitting diode; a first node electrode connected to a gate electrode of the driving transistor; a switching transistor connected between the data line and the first node electrode; a first initialization transistor connected between the reference voltage line and the first node electrode; and a second initialization transistor connected between the initialization voltage line and the first light-emitting diode. A pixel circuit layer including the first sub-pixel circuit may include: a semiconductor layer including a semiconductor pattern of the driving transistor; a first conductive layer on the semiconductor layer and including the gate electrode of the driving transistor; a second conductive layer on the first conductive layer and including the first node electrode; and a third conductive layer on the second conductive layer, the third conductive layer including a lower driving voltage included in the driving voltage line, the data line, the initialization voltage line, and the reference voltage line.

The driving voltage line may further include an upper driving voltage line on the lower driving voltage line, and the pixel circuit layer may include a fourth conductive layer on the third conductive layer and including the upper driving voltage line.

The display apparatus may include a common voltage line electrically connected to the first light-emitting diode to transmit a common voltage, wherein the common voltage line may include: a lower common voltage line included in the third conductive layer, the lower common voltage line being on a same layer as the lower driving voltage line; and an upper common voltage line included in the fourth conductive layer, the upper common voltage line being on another same layer as the upper driving voltage line.

The data line may overlap the upper common voltage line when viewed in a thickness direction of the display apparatus.

The first sub-pixel circuit further may include: an emission control transistor connected between the driving transistor and the first light-emitting diode; a second node electrode connecting the semiconductor pattern of the driving transistor to a semiconductor pattern of the emission control transistor; a storage capacitor connected between the first node electrode and the second node electrode; and a hold capacitor connected between the driving voltage line and the second node electrode. The second conductive layer may include the second node electrode. In one or more embodiments, an electronic apparatus may include: a processor; and the display apparatus controlled by the processor.

At least some of the above and other features of the invention are set out in the claims.

### BRIEF DESCRIPTION OF DRAWINGS

The above and other aspects, features, and advantages of certain embodiments of the disclosure will be more apparent from the following description taken in conjunction with the accompanying drawings, in which:
FIG. 1 is a schematic plan view of a display apparatus according to one or more embodiments;
FIG. 2 is a schematic plan view of a display apparatus according to one or more embodiments;
FIG. 3 is an equivalent circuit diagram of a light-emitting diode and a sub-pixel circuit of a display apparatus according to one or more embodiments;
FIG. 4 is a schematic plan view of sub-pixel circuits of a display apparatus according to one or more embodiments;
FIGS. 5 to 11 are schematic plan views of components of a display apparatus according to one or more embodiments for each layer;
FIG. 12 is a schematic cross-sectional view of a portion of a display apparatus according to one or more embodiments;
FIGS. 13A and 13B are schematic conceptual diagrams of arrangements of a plurality of voltage lines of a display apparatus according to one or more embodiments;
FIGS. 14A, 14B, and 14C are schematic plan views illustrating a third conductive layer, a fourth conductive layer, and a first electrode layer of a display apparatus according to one or more embodiments, respectively;
FIG. 15A is a schematic plan view of a portion of a peripheral area according to a comparative example;
FIG. 15B is a schematic plan view of a portion of a peripheral area of a display apparatus according to one or more embodiments;
FIGS. 16A and 16B are schematic conceptual diagrams of arrangements of a plurality of voltage lines of a display apparatus according to another embodiment;
FIG. 17 is a block diagram of an electronic apparatus according to one or more embodiments; and
FIG. 18 shows schematic diagrams of electronic apparatuses according to various embodiments.

### DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, the embodiments are merely described below, by referring to the figures, to explain aspects of the present description. As used herein, the term "and/or" includes any and all combinations of one or more of the associated listed items. Throughout the disclosure, the expression "at least one of a, b, and c" indicates only a, only b, only c, both a and b, both a and c, both b and c, all of a, b, and c, or variations thereof.

As the disclosure allows for various changes and numerous embodiments, particular embodiments will be illustrated in the drawings and described in detail in the written description. Effects and features of the disclosure and methods of achieving the same will be apparent with reference to embodiments and drawings described below in detail. The disclosure may, however, be embodied in many different forms and should not be construed as being limited to the embodiments set forth herein.

The disclosure will now be described more fully with reference to the accompanying drawings, in which embodiments are shown. Like reference numerals in the drawings denote like elements, and thus their description will not be repeated.

In the following embodiments, while such terms as "first," "second," etc., may be used to describe various elements, such elements must not be limited to the above terms.

In the following embodiments, an expression used in the singular encompasses the expression of the plural, unless it has a clearly different meaning in the context.

In the following embodiments, it is to be understood that the terms such as "including" and "having" are intended to indicate the existence of the features, or elements disclosed in the disclosure, and are not intended to preclude the possibility that one or more other features or elements may exist or may be added.

It will be understood that when a layer, region, or element is referred to as being formed on another layer, region, or element, it can be directly or indirectly formed on the other layer, region, or element, that is, for example, intervening layers, regions, or elements may be present. Further, when two or more elements (or components, or layers) are described as being "electrically connected," these two or more elements may be in a state of electrically connected through a conductive medium such as wire or being configured to be electrically connected through the conductive medium when power is supplied to a device including the two or more elements.

Sizes of elements in the drawings may be exaggerated or reduced for convenience of explanation. For example, since sizes and thicknesses of components in the drawings are arbitrarily illustrated for convenience of explanation, the following embodiments are not limited thereto.

When a certain embodiment may be implemented differently, a specific process order may be performed differently from the described order. For example, two consecutively described processes may be performed substantially at the same time or performed in an order opposite to the described order.

It will be understood that when a layer, region, or component is referred to as being connected to another layer, region, or component, it can be directly or indirectly connected to the other layer, region, or component. That is, for example, intervening layers, regions, or components may be present. For example, it will be understood that when a layer, region, or component is referred to as being electrically connected to another layer, region, or component, it can be directly or indirectly electrically connected to the other layer, region, or component. That is, for example, intervening layers, regions, or components may be present.

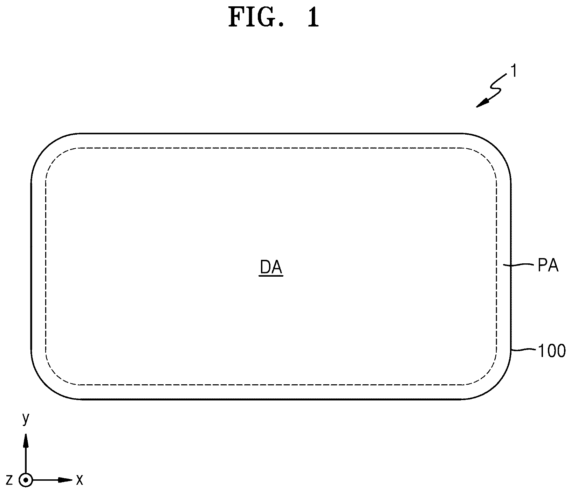

FIG. 1 is a schematic plan view of a display apparatus according to one or more embodiments.

Referring to FIG. 1, a display apparatus 1 may include a display area DA displaying an image and a peripheral area PA outside the display area DA. The display apparatus 1 may provide an image through an array of sub-pixels arranged two-dimensionally in the display area DA. Each of the sub-pixels of the display apparatus 1 is an area capable of emitting a certain color of light, and the display apparatus 1 may provide an image by using light emitted from the sub-pixels. For example, each sub-pixel may emit red, green, blue, or white light.

Each of the sub-pixels may emit light of a certain color by using a light-emitting diode, for example, an organic light-emitting diode. Each organic light-emitting diode may emit, for example, red, green, blue, or white light. Each organic light-emitting diode may be connected to a sub-pixel circuit including a thin-film transistor and a capacitor.

The peripheral area PA is an area which does not provide an image, and may entirely surround the display area DA. A driver or a main power line, which is configured to provide an electrical signal or power to sub-pixel circuits, may be arranged in the peripheral area PA. A pad, which is an area to which an electronic device or a printed circuit board may be electrically connected, may be arranged in the peripheral area PA.

In a plan view of the display area DA, the display area DA may have a roughly quadrangular shape with rounded corners. In another embodiment, the display area DA may have a polygonal shape, such as a triangular shape, a pentagonal shape, a hexagonal shape, or the like, or a circular shape, an elliptical shape, an atypical shape, or the like.

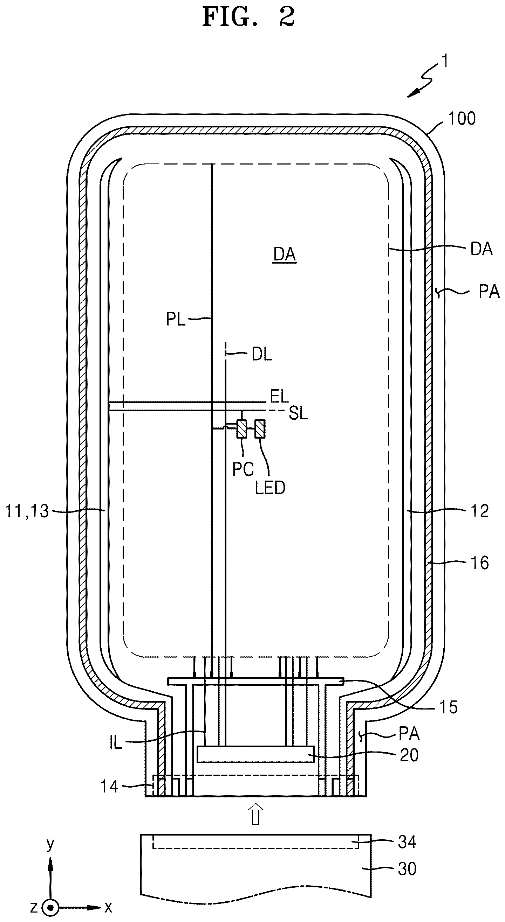

FIG. 2 is a schematic plan view of the display apparatus 1 according to one or more embodiments.

Referring to FIG. 2, the display apparatus 1 may include a substrate 100. Various components forming the display apparatus 1 may be disposed on the substrate 100.

The substrate 100 may include glass, metal, or polymer resin. The substrate 100 may include, for example, a polymer resin such as polyethersulfone, polyacrylate, polyetherimide, polyethylene naphthalate, polyethylene terephthalate, polyphenylene sulfide, polyarylate, polyimide, polycarbonate, or cellulose acetate propionate. The substrate 100 may have a multi-layered structure including two layers each including the polymer resin described above and an inorganic layer arranged between the two layers.

Sub-pixels may be arranged in the display area DA, and the display area DA may provide an image by using light emitted from the sub-pixels. Each sub-pixel may include a light-emitting diode LED, and the light-emitting diode LED may be electrically connected to a sub-pixel circuit PC. The sub-pixel circuit PC and the light-emitting diode LED may be arranged in the display area DA.

Gate driving circuits (e.g., a first scan driving circuit 11, a second scan driving circuit 12, and an emission control driving circuit 13), a pad 14, a driving voltage supply line 15, and a common voltage supply line 16 may be arranged in the peripheral area PA.

The first scan driving circuit 11 may provide a scan signal to the sub-pixel circuit PC through a gate line SL. The second scan driving circuit 12 may be arranged on the opposite side of the first scan driving circuit 11 with the display area DA therebetween. Some of the sub-pixel circuits PC arranged in the display area DA may be electrically connected to the first scan driving circuit 11, and the remaining sub-pixel circuits PC may be connected to the second scan driving circuit 12. In another embodiment, the second scan driving circuit 12 may be omitted.

The emission control driving circuit 13 may be arranged on the side of the first scan driving circuit 11 and provide an emission control signal to a sub-pixel through an emission control line EL. FIG. 2 illustrates that the emission control driving circuit 13 is arranged only on one side of the display area DA, but the disclosure is not limited thereto. In another embodiment, emission control driving circuits 13 may be arranged on both sides of the display area DA.

The pad 14 may be arranged in the peripheral area PA of the substrate 100. The pad 14 may be exposed by not being covered with an insulating layer and may be electrically connected to a display circuit board 30. A pad 34 of the display circuit board 30 may be electrically connected to the pad 14 of the display apparatus 1.

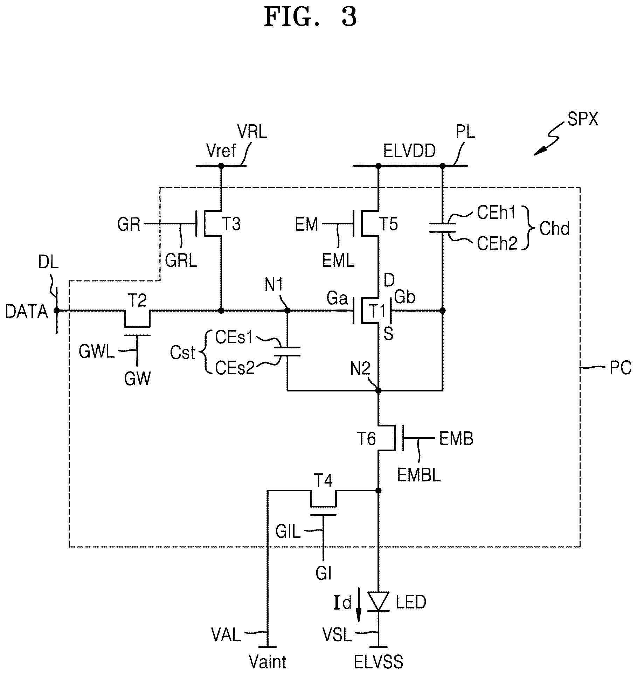

The display circuit board 30 may transmit a signal or power of a controller to the display apparatus 1. A control signal generated by the controller may be transmitted to each of the gate driving circuits through the display circuit board 30. In addition, the controller may provide a driving voltage ELVDD (refer to FIG. 3) to the driving voltage supply line 15, and may provide a common voltage ELVSS (refer to FIG. 3) to the common voltage supply line 16. The driving voltage ELVDD

(refer to FIG. 3) may be provided to each sub-pixel circuit PC through a driving voltage line PL connected to the driving voltage supply line 15, and the common voltage ELVSS (refer to FIG. 3) may be provided to an opposite electrode of the light-emitting diode LED connected to the common voltage supply line 16. The driving voltage supply line 15 may extend in a first direction (e.g., an x-axis direction). The common voltage supply line 16 may have a loop shape with one side open to partially surround the display area DA.

A data signal of a data driver 20 may be transmitted to the sub-pixel circuit PC through an input line IL and a data line DL electrically connected to the input line IL.

FIG. 3 is an equivalent circuit diagram of the light-emitting diode LED and the sub-pixel circuit PC of a display apparatus according to one or more embodiments.

Referring to FIG. 3, a sub-pixel SPX may include the light-emitting diode LED as a display element and the sub-pixel circuit PC connected to the light-emitting diode LED. The sub-pixel circuit PC may include first to sixth transistors T1 to T6, a storage capacitor Cst, and a hold capacitor Chd. The first transistor T1 may be a driving transistor that outputs a driving current corresponding to a data signal, and the second to sixth transistors T2 to T6 may be switching transistors configured to transfer signals. A first terminal (first electrode) of each of the first to sixth transistors T1 to T6 may be a source or drain, and a second terminal (second electrode) thereof may be a terminal that is different from the first terminal. For example, when the first terminal is a drain, the second terminal may be a source.

In one or more embodiments, at least one of the first to sixth transistors T1, T2, T3, T4, T5, and T6 may be a p-channel metal-oxide-semiconductor field-effect transistor (MOSFET) (PMOS), and the remaining may be n-channel MOSFETs (NMOS). For example, the fifth transistor T5 may be a PMOS, and the first, second, third, fourth, and sixth transistors T1, T2, T3, T4, and T6 may be NMOSs. In another embodiment, the fifth transistor T5 and the sixth transistor T6 may be PMOSs, and the first, second, third, and fourth transistors T1, T2, T3, and T4 may be NMOSs. Alternatively, the first to sixth transistors T1, T2, T3, T4, T5, and T6 may all be NMOSs or PMOSs. Hereinafter, one or more embodiments in which each of the first to sixth transistors T1, T2, T3, T4, T5, and T6 is an NMOS including an oxide semiconductor is mainly described.

The sub-pixel circuit PC may be electrically connected to the gate line SL (refer to FIG. 2) or emission control line EL (refer to FIG. 2) configured to transfer a signal to a gate of each of the first to sixth transistors T1, T2, T3, T4, T5, and T6. For example, the sub-pixel circuit PC may be connected to a scan line GWL configured to transfer a scan signal GW, an initialization gate line GIL configured to transfer an initialization signal GI, a reference gate line GRL configured to transfer a reference signal GR, a first emission control line EML configured to transfer a first emission control signal EM, and a second emission control line EMBL configured to transfer a second emission control signal EMB. In addition, the sub-pixel circuit PC may be connected to a data line DL configured to transfer a data signal DATA, a driving voltage line PL configured to transfer a driving voltage ELVDD, a reference voltage line VRL configured to transfer a reference voltage Vref, and an initialization voltage line VAL configured to transfer an initialization voltage Vaint.

The first transistor T1 may be electrically connected between the driving voltage line PL and a second node N2. The first transistor T1 may include a gate connected to a first node N1, a first terminal connected to the driving voltage line PL, and a second terminal connected to the second node N2. The first terminal may be a drain D, and the second terminal may be a source S. The first transistor T1 may have a dual-gate structure. The first transistor T1 may further include a lower gate electrode Gb overlapping a channel area of the first transistor T1, in addition to an upper gate electrode Ga connected to the first node N1. For example, the upper gate electrode Ga and the lower gate electrode Gb of the first transistor T1 may be positioned to face each other with a semiconductor layer therebetween.

The first terminal of the first transistor T1 may be connected to the driving voltage line PL via the fifth transistor T5, and the second terminal thereof may be connected to a pixel electrode of the light-emitting diode LED. The first transistor T1 may receive the data signal DATA in response to a switching operation of the second transistor T2 and control the amount of driving current I_{d} flowing to the light-emitting diode LED. Accordingly, the first transistor T1 may be referred to as a driving transistor.

The second transistor T2 may be connected between the data line DL and the first node N1. The second transistor T2 may include a gate connected to the scan line GWL, a first terminal connected to the data line DL, and a second terminal connected to the first node N1. The second transistor T2 may be turned on by the scan signal GW transmitted through the scan line GWL to electrically connect the data line DL to the first node N1, and the data signal DATA transmitted through the data line DL may be transmitted to the first node N1. Accordingly, the second transistor T2 may be referred to as a switching transistor.

The third transistor T3 may be connected between the first node N1 and the reference voltage line VRL. The third transistor T3 may include a gate connected to the reference gate line GRL, a first terminal connected to the first node N1, and a second terminal connected to the reference voltage line VRL. The third transistor T3 may be turned on by the reference signal GR transmitted through the reference gate line GRL to be configured to transmit the reference voltage Vref transmitted through the reference voltage line VRL to the first node N1. The third transistor T3 may be referred to as a first initialization transistor.

The fourth transistor T4 may be connected between the first transistor T1 and the initialization voltage line VAL. The fourth transistor T4 may include a gate connected to the initialization gate line GIL, a first terminal connected to the sixth transistor T6 and the light-emitting diode LED, and a second terminal connected to the initialization voltage line VAL. The fourth transistor T4 may be turned on by the initialization signal GI transmitted through the initialization gate line GIL to be configured to transmit the initialization voltage Vaint transmitted through the initialization voltage line VAL to the pixel electrode of the light-emitting diode LED. Accordingly, the fourth transistor T4 may be referred to as a second initialization transistor.

The fifth transistor T5 may be electrically connected between the driving voltage line PL and the first transistor T1. The fifth transistor T5 may include a gate connected to the first emission control line EML, a first terminal connected to the driving voltage line PL, and a second terminal connected to the first terminal of the first transistor T1. The fifth transistor T5 may be turned on or off in response to the first emission control signal EM transmitted through the first emission control line EML. The fifth transistor T5 may be referred to as a driving control transistor.

The sixth transistor T6 may be connected between the first transistor T1 and the light-emitting diode LED. The sixth transistor T6 may include a gate connected to the second emission control line EMBL, a first terminal connected to the second node N2, and a second terminal connected to the light-emitting diode LED. The sixth transistor T6 may be turned on by the second emission control signal EMB transmitted through the second emission control line EMBL to connect the second node N2 to the pixel electrode of the light-emitting diode LED. The sixth transistor T6 may be referred to as an emission control transistor.

FIG. 3 illustrates that the fifth transistor T5 and the sixth transistor T6 operate in response to different emission control signals (i.e., first and second emission control signals EM and EMB), respectively, but the fifth transistor T5 and the sixth transistor T6 may also operate in response to the same emission control signal.

In one or more embodiments, the reference signal GR may be substantially synchronized with a scan signal GW of a sub-pixel circuit PC positioned in a previous row. The initialization signal GI may be substantially synchronized with the scan signal GW. In another embodiment, the initialization signal GI may be substantially synchronized with a scan signal GW or reference signal GR of a sub-pixel circuit PC positioned in the next row.

The storage capacitor Cst may be connected between the first node N1 and the second node N2. In other words, the sub-pixel circuit PC according to one or more embodiments may be a source-follower-type circuit in which the storage capacitor Cst is connected between the first node N1 and the second node N2. A first storage electrode CEs1 of the storage capacitor Cst may be connected to the first node N1, and a second storage electrode CEs2 may be connected to the second node N2. The storage capacitor Cst may store a threshold voltage of the first transistor T1 and a voltage corresponding to the data signal DATA.

The hold capacitor Chd may be connected between the driving voltage line PL and the second node N2. A first hold electrode CEh1 of the hold capacitor Chd may be connected to the driving voltage line PL, and a second hold electrode CEh2 may be connected to the second node N2. The hold capacitor Chd may allow voltages of the lower gate electrode Gb of the first transistor T1 and the second node N2 to have constant voltages without fluctuation, even when surrounding signals fluctuate.

The light-emitting diode LED may include a pixel electrode connected to the second node N2 and an opposite electrode on the pixel electrode, and the opposite electrode may receive the common voltage ELVSS through a common voltage line VSL connected to the common voltage supply line 16 (refer to FIG. 2). The opposite electrode may be a common electrode shared between a plurality of light-emitting diodes LED.

FIG. 3 illustrates that the sub-pixel circuit PC includes six transistors and two capacitors, but the disclosure is not limited thereto. In another embodiment, the sub-pixel circuit PC may include five transistors and two capacitors. In another embodiment, the sub-pixel circuit PC may include seven transistors and two capacitors.

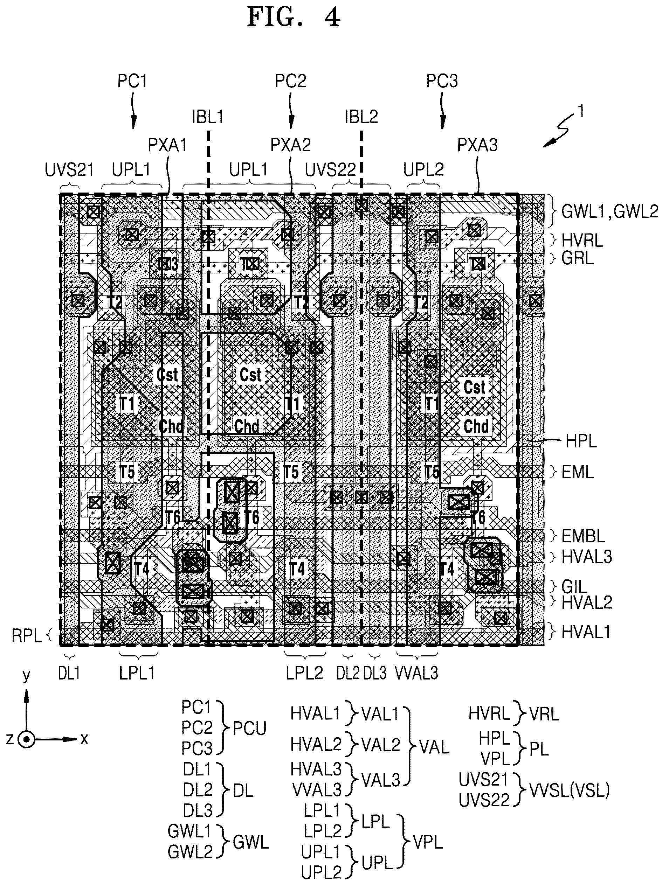

FIG. 4 is a schematic plan view of sub-pixel circuits of a display apparatus according to one or more embodiments. For convenience of explanation, FIG. 4 shows three sub-pixel circuit areas arranged in the same row in a first direction (e.g., an x-axis direction), for example, a first sub-pixel circuit area PXA1, a second sub-pixel circuit area PXA2, and a third sub-pixel circuit area PXA3, but the disclosure is not limited thereto. The display apparatus 1 may include a plurality of sub-pixel circuit areas arranged in rows in the first direction (e.g., the x-axis direction) and columns in a second direction (e.g., a y-axis direction).

Referring to FIG. 4, the display apparatus 1 may include the first sub-pixel circuit area PXA1, the second sub-pixel circuit area PXA2, and the third sub-pixel circuit area PXA3, which are sequentially arranged in the first direction (e.g., the x-axis direction). For example, the first sub-pixel circuit area PXA1 may be an area in which a first sub-pixel circuit PC1 connected to the light-emitting diode LED (refer to FIG. 3) emitting red light is arranged. The second sub-pixel circuit area PXA2 may be an area in which a second sub-pixel circuit PC2 connected to the light-emitting diode LED (refer to FIG. 3) emitting green light is arranged. The third sub-pixel circuit area PXA3 may be an area in which a third sub-pixel circuit PC3 connected to the light-emitting diode LED (refer to FIG. 3) emitting blue light is arranged.

As shown in FIG. 4, the first sub-pixel circuit PC1, the second sub-pixel circuit PC2, and the third sub-pixel circuit PC3, which are sequentially arranged in the first direction (e.g., the x-axis direction), may configure one sub-pixel circuit unit PCU. As described above, the sub-pixel circuit unit PCU including three sub-pixel circuits may be repeatedly arranged in the first direction (e.g., the x-axis direction) and the second direction (e.g., the y-axis direction).

Each of the first sub-pixel circuit PC1, the second sub-pixel circuit PC2, and the third sub-pixel circuit PC3 may include transistors and capacitors. For example, the first to sixth transistors T1, T2, T3, T4, T5, and T6, the storage capacitor Cst, and the hold capacitor Chd, which are described above with reference to FIG. 3, may be arranged in each of the first sub-pixel circuit area PXA1, the second sub-pixel circuit area PXA2, and the third sub-pixel circuit area PXA3.

Each of the first sub-pixel circuit PC1, the second sub-pixel circuit PC2, and the third sub-pixel circuit PC3 may be electrically connected to signal lines transmitting signals to the gate of each of the first to sixth transistors T1, T2, T3, T4, T5, and T6. For example, each of the first sub-pixel circuit PC1, the second sub-pixel circuit PC2, and the third sub-pixel circuit PC3 may be connected to the scan line GWL configured to transmit a scan signal, the initialization gate line GIL configured to transmit an initialization signal, the reference gate line GRL configured to transmit a reference signal, the first emission control line EML configured to transmit a first emission control signal, and the second emission control line EMBL configured to transmit a second emission control signal. In addition, each of the first sub-pixel circuit PC1, the second sub-pixel circuit PC2, and the third sub-pixel circuit PC3 may be connected to the data line DL configured to transmit a data signal, the driving voltage line PL configured to transmit a driving voltage, the reference voltage line VRL configured to transmit a reference voltage, and the initialization voltage line VAL configured to transmit an initialization voltage.

Referring to FIG. 4, the transistors and capacitors of the first sub-pixel circuit PC1 may be arranged symmetrically with the transistors and capacitors of the second sub-pixel circuit PC2. For example, the first transistor T1 of the first sub-pixel circuit PC1 may be symmetrical with the first transistor T1 of the second sub-pixel circuit PC2 with respect to a virtual line IBL1 passing between the first sub-pixel circuit PC1 and the second sub-pixel circuit PC2 in the second direction (e.g., the y-axis direction). Similarly, the second to sixth transistors T2, T3, T4, T5, and T6, the storage capacitor Cst, and the hold capacitor Chd of the first sub-pixel circuit PC1 may be respectively symmetrical with the second to sixth transistors T2, T3, T4, T5, and T6, the storage capacitor Cst, and the hold capacitor Chd of the second sub-pixel circuit PC2 with respect to the virtual line IBL1.

Similarly, the transistors and capacitors of the second sub-pixel circuit PC2 may be arranged symmetrically with the transistors and capacitors of the third sub-pixel circuit PC3. For example, the first transistor T1 of the second sub-pixel circuit PC2 may be symmetrical with the first transistor T1 of the third sub-pixel circuit PC3 with respect to a virtual line IBL2 passing between the second sub-pixel circuit PC2 and the third sub-pixel circuit PC3 in the second direction (e.g., the y-axis direction). Similarly, the second to sixth transistors T2, T3, T4, T5, and T6, the storage capacitor Cst, and the hold capacitor Chd of the second sub-pixel circuit PC2 may be respectively symmetrical with the second to sixth transistors T2, T3, T4, T5, and T6, the storage capacitor Cst, and the hold capacitor Chd of the third sub-pixel circuit PC3 with respect to the virtual line IBL2.

Gate lines electrically connected to the first sub-pixel circuit PC1, the second sub-pixel circuit PC2, and the third sub-pixel circuit PC3, for example, the scan line GWL, the initialization gate line GIL, the reference gate line GRL, the first emission control line EML, and the second emission control line EMBL, may extend in the first direction (e.g., the x-axis direction).

The first sub-pixel circuit PC1, the second sub-pixel circuit PC2, and the third sub-pixel circuit PC3 may be electrically connected to data lines DL passing through corresponding sub-pixel circuit areas. For example, the first sub-pixel circuit PC1 may be electrically connected to a first data line DL1 passing through the first sub-pixel circuit area PXA1, the second sub-pixel circuit PC2 may be electrically connected to a second data line DL2 passing through the second sub-pixel circuit area PXA2, and the third sub-pixel circuit PC3 may be connected to a third data line DL3 passing through the third sub-pixel circuit area PXA3. The data line DL may extend in the second direction (e.g., the y-axis direction).

Based on the first direction (e.g., the x-axis direction), the first data line DL1 may be arranged to the left side of the first transistor T1 within the first sub-pixel circuit area PXA1, the second data line DL2 may be arranged to the right side of the first transistor T1 within the second sub-pixel circuit area PXA2, and the third data line DL3 may be arranged to the left side of the first transistor T1 within the third sub-pixel circuit area PXA3. In other words, the first data line DL1 and the second data line DL2 may be arranged far apart from each other with respect to the virtual line IBL1, and the second data line DL2 and the third data line DL3 may be arranged adjacent to each other with respect to the virtual line IBL2.

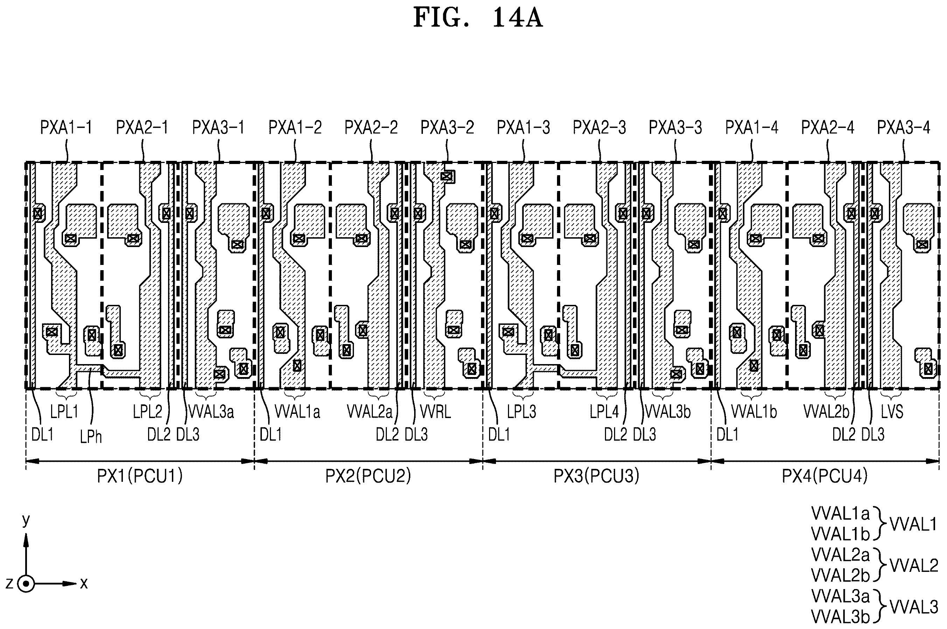

The first sub-pixel circuit PC1, the second sub-pixel circuit PC2, and the third sub-pixel circuit PC3 may be electrically connected to a plurality of voltage lines disposed on the sub-pixel circuit unit PCU. For example, each of the first sub-pixel circuit PC1, the second sub-pixel circuit PC2, and the third sub-pixel circuit PC3 may be electrically connected to the reference voltage line VRL, the initialization voltage line VAL, the driving voltage line PL, and the common voltage line VSL. The reference voltage line VRL may include a horizontal reference voltage line HVRL extending in the first direction (e.g., the x-axis direction) and a vertical reference voltage line VVRL (refer to FIG. 14A) which is not shown in FIG. 4 but extends in the second direction (e.g., the y-axis direction). The horizontal reference voltage line HVRL and the vertical reference voltage line VVRL (refer to FIG. 14A) may be electrically connected to each other in an intersecting area.

The initialization voltage line VAL may include a first initialization voltage line VAL1 connected to the first sub-pixel circuit PC1, a second initialization voltage line VAL2 connected to the second sub-pixel circuit PC2, and a third initialization voltage line VAL3 connected to the third sub-pixel circuit PC3. Each of the first to third initialization voltage lines VAL1, VAL2, and VAL3 may include a horizontal initialization voltage line extending in the first direction (e.g., the x-axis direction) and a vertical initialization voltage line extending in the second direction (e.g., the y-axis direction). For example, the first initialization voltage line VAL1 may include a first horizontal initialization voltage line HVAL1 extending in the first direction (e.g., the x-axis direction) and a first vertical initialization voltage line VVAL1 (refer to FIG. 14A) which is not shown in FIG. 4 but extends in the second direction (e.g., the y-axis direction). Similarly, the second initialization voltage line VAL2 may include a second horizontal initialization voltage line HVAL2 extending in the first direction (e.g., the x-axis direction) and a second vertical initialization voltage line VVAL2 (refer to FIG. 14A) which is not shown in FIG. 4 but extends in the second direction (e.g., the y-axis direction). The third initialization voltage line VAL3 may include a third horizontal initialization voltage line HVAL3 extending in the first direction (e.g., the x-axis direction) and a third vertical initialization voltage line VVAL3 extending in the second direction (e.g., the y-axis direction).

The driving voltage line PL may include a horizontal driving voltage line HPL extending in the first direction (e.g., the x-axis direction) and a vertical driving voltage line VPL extending in the second direction (e.g., the y-axis direction). The horizontal driving voltage line HPL and the vertical driving voltage line VPL may be electrically connected to each other in an intersecting area. In one or more embodiments, the vertical driving voltage line VPL may include a lower driving voltage line LPL and an upper driving voltage line UPL, which are disposed on different layers.

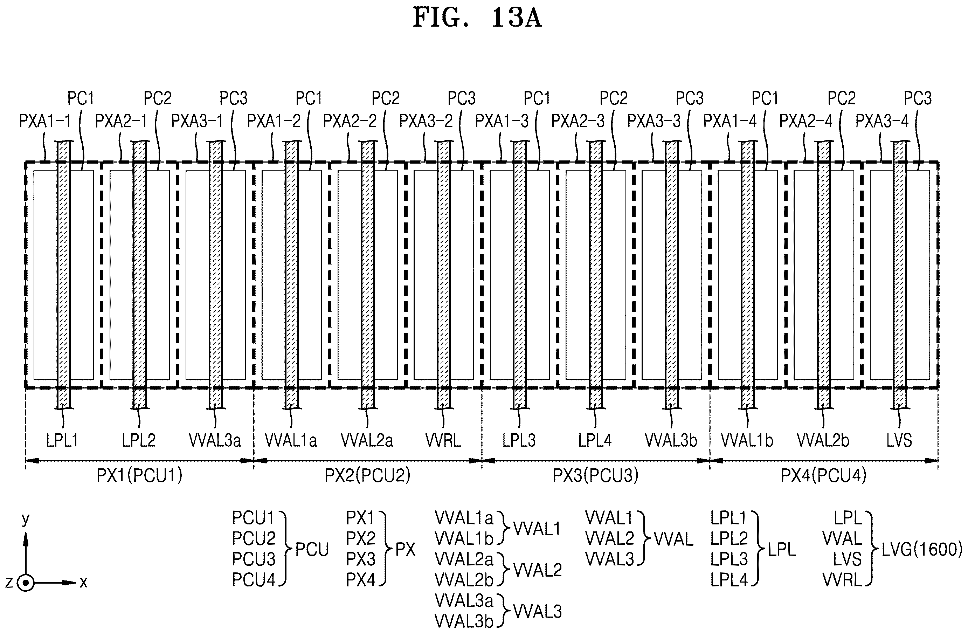

The lower driving voltage line LPL may include a first lower driving voltage line LPL1 passing through the first sub-pixel circuit area PXA1 and extending in the second direction (e.g., the y-axis direction) and a second lower driving voltage line LPL2 passing through the second sub-pixel circuit area PXA2 and extending in the second direction (e.g., the y-axis direction). The upper driving voltage line UPL may include a first upper driving voltage line UPL1 arranged across the first sub-pixel circuit area PXA1 and the second sub-pixel circuit area PXA2 and extending in the second direction (e.g., the y-axis direction) and a second upper driving voltage line UPL2 passing through the third sub-pixel circuit area PXA3 and extending in the second direction (e.g., the y-axis direction). The driving voltage line PL is described in detail below with reference to FIGS. 13A to 14B.

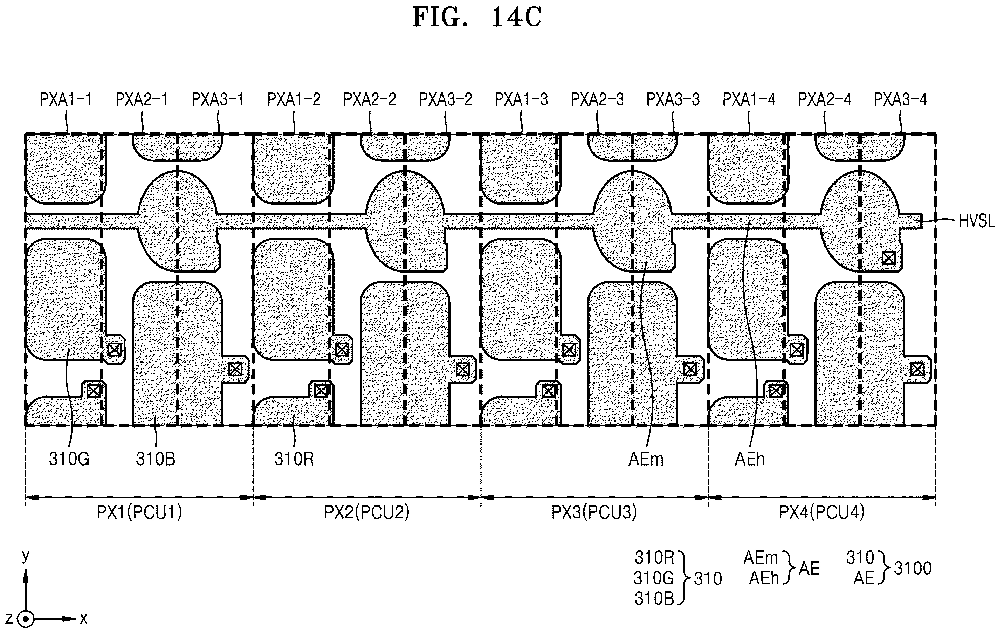

The common voltage line VSL may include a horizontal common voltage line HVSL (refer to FIG. 14C) which is not shown in FIG. 4 but extends in the first direction (e.g., the x-axis direction) and a vertical common voltage line VVSL extending in the second direction (e.g., the y-axis direction). The horizontal common voltage line HVSL (refer to FIG. 14C) and the vertical common voltage line VVSL may be electrically connected to each other in an intersecting area. The horizontal common voltage line HVSL (refer to FIG. 14C) may extend in the first direction (e.g., the x-axis direction) to pass through the first sub-pixel circuit PC1, the second sub-pixel circuit PC2, and the third sub-pixel circuit PC3. The vertical common voltage line VVSL may include a second-1 upper common voltage line UVS21 passing through the first sub-pixel circuit area PXA1 and extending in the second direction (e.g., the y-axis direction) and a second-2 upper common voltage line UVS22 arranged across the second sub-pixel circuit area PXA2 and the third sub-pixel circuit area PXA3 and extending in the second direction (e.g., the y-axis direction). The common voltage line VSL is described in detail below with reference to FIGS. 13A to 14C.

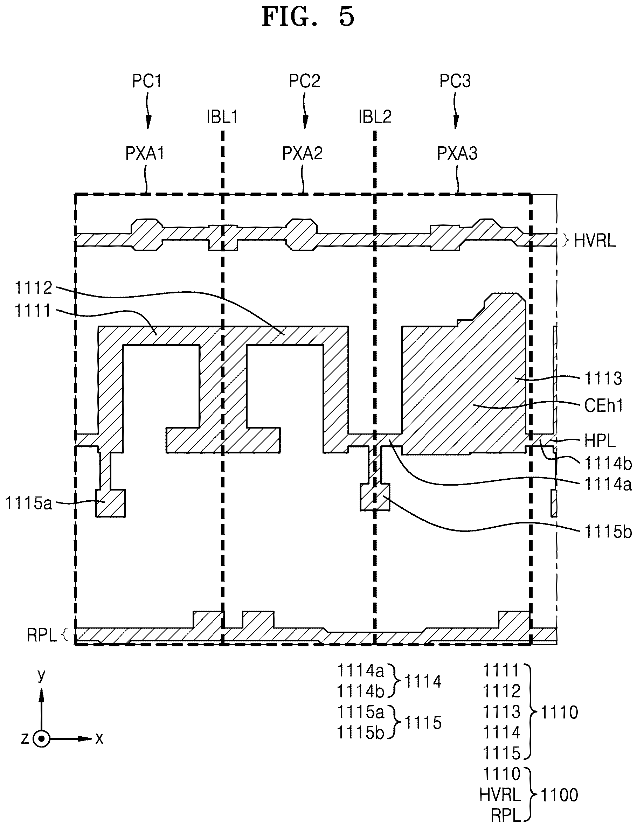

FIGS. 5 to 11 are schematic plan views of components of a display apparatus according to one or more embodiments for each layer.

First, referring to FIG. 5, a first lower metal layer 1100 may be disposed on a substrate. The first lower metal layer 1100 may include aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W), and/or copper (Cu), and may include a single layer or a multi-layer, each including the above material.

The first lower metal layer 1100 may include a first conductive pattern 1110, the horizontal reference voltage line HVRL, and a repair line RPL. The first conductive pattern 1110, the horizontal reference voltage line HVRL, and the repair line RPL may be arranged to be spaced apart from each other in a vertical direction (e.g., the y-axis direction).

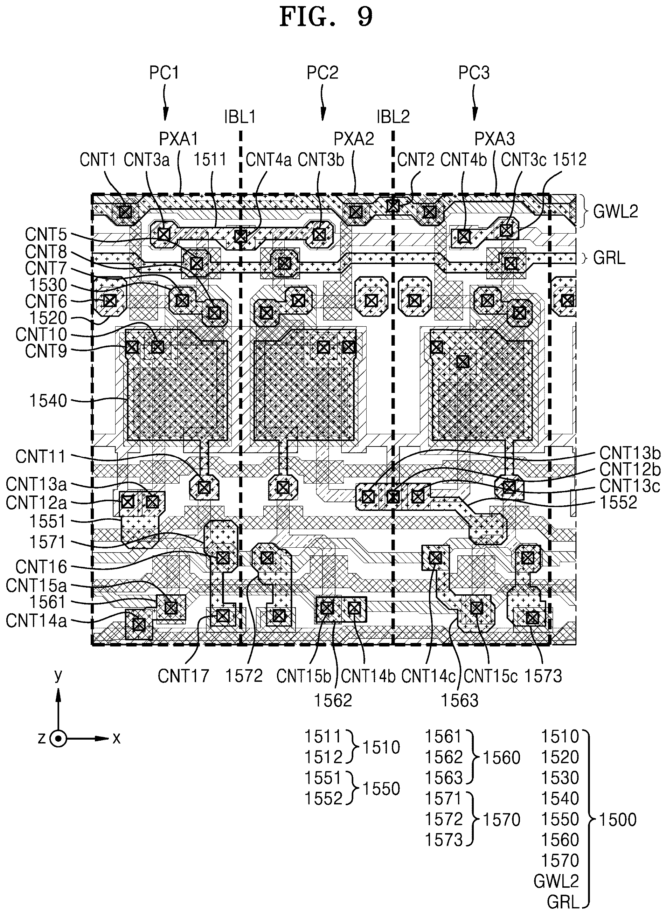

The horizontal reference voltage line HVRL may extend in the first direction (e.g., the x-axis direction) to pass through the first sub-pixel circuit PC1, the second sub-pixel circuit PC2, and the third sub-pixel circuit PC3. The horizontal reference voltage line HVRL may pass through sub-pixel circuits arranged in the same row as the first sub-pixel circuit PC1, the second sub-pixel circuit PC2, and the third sub-pixel circuit PC3. The horizontal reference voltage line HVRL may be electrically connected to a vertical reference voltage line VVRL (refer to FIG. 14A) to be described below. The horizontal reference voltage line HVRL may transmit a reference voltage to each sub-pixel circuit through a seventh conductive pattern 1510 (refer to FIG. 9) to be described below.

The repair line RPL may extend in the first direction (e.g., the x-axis direction) to pass through the first sub-pixel circuit PC1, the second sub-pixel circuit PC2, and the third sub-pixel circuit PC3. The repair line RPL may pass through the sub-pixel circuits arranged in the same row as the first sub-pixel circuit PC1, the second sub-pixel circuit PC2, and the third sub-pixel circuit PC3. When a sub-pixel circuit is defective, the light-emitting diode LED may be separated and/or disconnected from the defective sub-pixel circuit, and instead connected to a dummy circuit through the repair line RPL. The dummy circuit may generate a driving current corresponding to a data signal and supply the driving current to the light-emitting diode LED through the repair line RPL so that the light-emitting diode LED may normally operate.

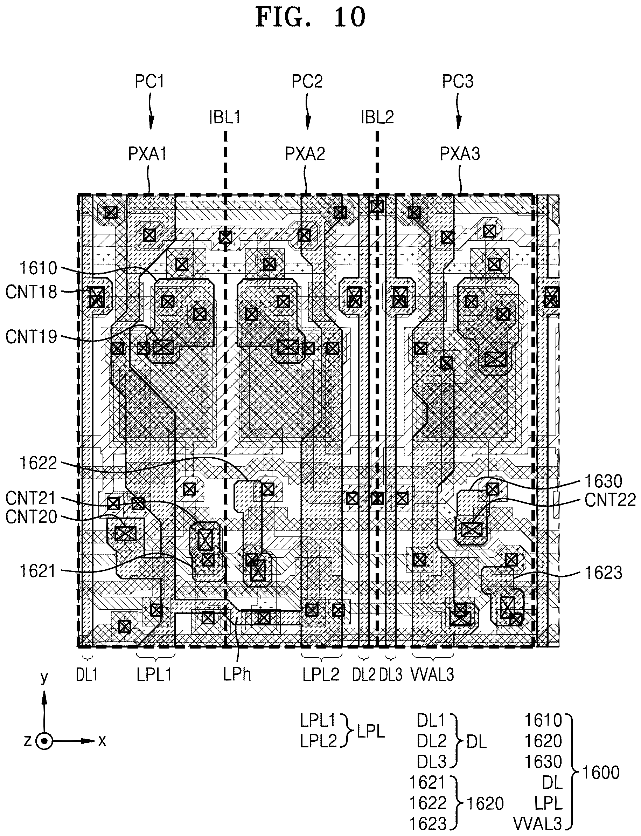

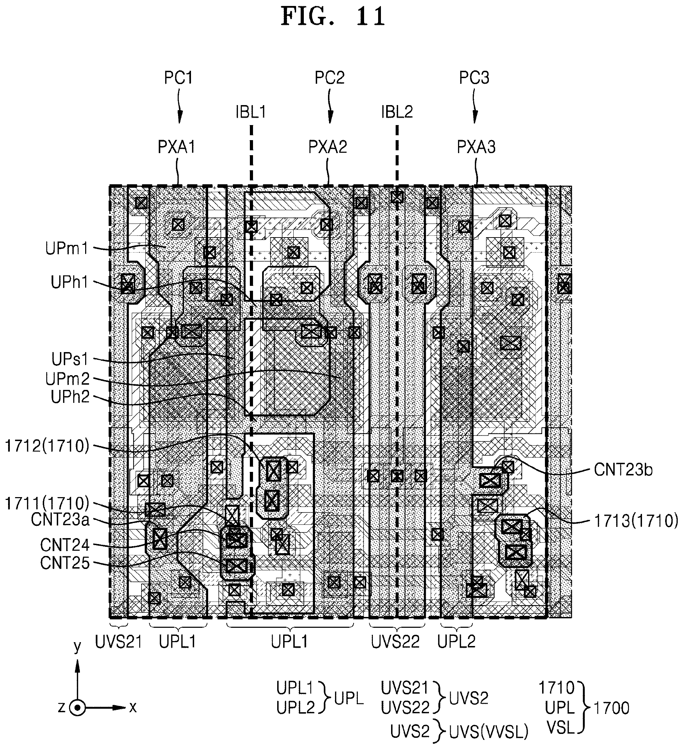

The first conductive pattern 1110 may extend in the first direction (e.g., the x-axis direction) to pass through the first sub-pixel circuit PC1, the second sub-pixel circuit PC2, and the third sub-pixel circuit PC3. The first conductive pattern 1110 may pass through the sub-pixel circuits arranged in the same row as the first sub-pixel circuit PC1, the second sub-pixel circuit PC2, and the third sub-pixel circuit PC3. The first conductive pattern 1110 may be electrically connected to a lower driving voltage line LPL (refer to FIG. 10) and an upper driving voltage line UPL (refer to FIG. 11), which will be described below, to receive a driving voltage. The first conductive pattern 1110 may supply the received driving voltage to the sub-pixel circuits arranged in the same row. Accordingly, the first conductive pattern 1110 may be referred to as the horizontal driving voltage line HPL.

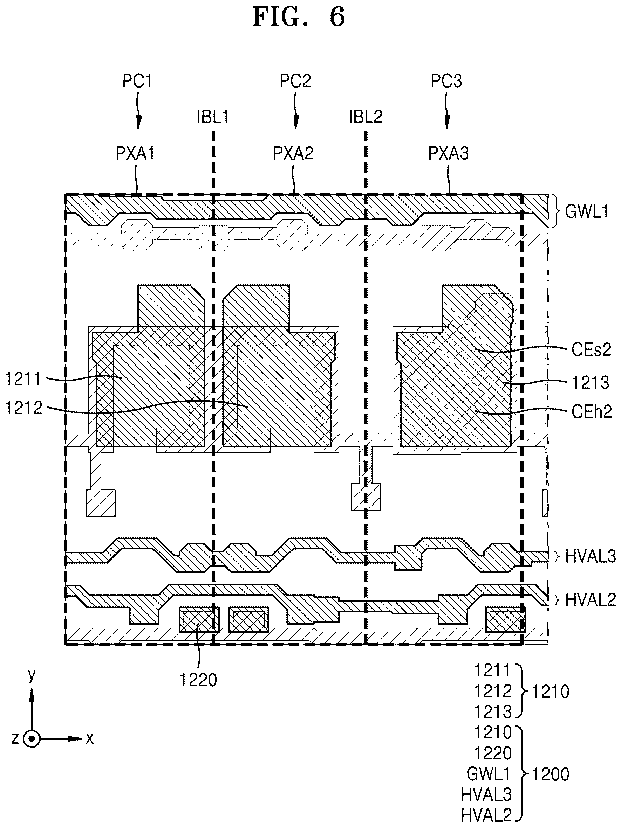

The first conductive pattern 1110 may include a first main portion 1111 arranged in the first sub-pixel circuit area PXA1, a second main portion 1112 arranged in the second sub-pixel circuit area PXA2, and a third main portion 1113 arranged in the third sub-pixel circuit area PXA3. Each of the first main portion 1111, the second main portion 1112, and the third main portion 1113 may partially overlap a second conductive pattern 1210 (refer to FIG. 6) to be described below. The overlapping areas of the first main portion 1111, the second main portion 1112, and the third main portion 1113, which overlap the second conductive pattern 1210 (refer to FIG. 6) in a plan view, may correspond to the first hold electrode CEh1 of the hold capacitor Chd (refer to FIG. 3).

Each of the first main portion 1111 and the second main portion 1112 may have a loop shape with an open lower side, or a quadrangular frame shape with an open lower side. The shape of the first main portion 1111 and the second main portion 1112 may form a continuous boundary, but with an open gap at the bottom. The first main portion 1111 and the second main portion 1112 may be symmetrical with respect to the virtual line IBL1, and the first main portion 1111 and the second main portion 1112 may be integrally formed as a single body. The third main portion 1113 may have a quadrangular shape having a protruding portion at the upper-right side, forming a distinct feature compared to the first main portion 1111 and the second main portion 1112.

The first main portion 1111, the second main portion 1112, and the third main portion 1113 may be integrally formed. When the first main portion 1111, the second main portion 1112, and the third main portion 1113 are arranged to be spaced apart from each other, the first main portion 1111, the second main portion 1112, and the third main portion 1113 may be connected to each other through a horizontal portion 1114. For example, the first conductive pattern 1110 may include a first horizontal portion 1114a connecting the second main portion 1112 to the third main portion 1113, and a second horizontal portion 1114b connecting the third main portion 1113 to the first main portion 1111 of a first sub-pixel circuit PC1 of an adjacent sub-pixel circuit unit PCU.

The first conductive pattern 1110 may further include a protruding portion 1115 protruding toward the repair line RPL in the second direction (e.g., the y-axis direction). The protruding portion 1115 allows the first conductive pattern 1110 to receive a driving voltage through a contact hole formed in the protruding portion 1115. In particular, the first conductive pattern 1110 may include two branches, a first protruding portion 1115a that extends and branches from the first main portion 1111, and a second protruding portion 1115b that extends and branches from the first horizontal portion 1114a.

Referring to FIG. 6, a second lower metal layer 1200 may be disposed on the first lower metal layer 1100. The second lower metal layer 1200 may include Al, Pt, Pd, Ag, Mg, Au, Ni, Nd, Ir, Cr, Li, Ca, Mo, Ti, W, and/or Cu, and may include a single layer or a multi-layer, each including the above material.

The second lower metal layer 1200 may include a second conductive pattern 1210, a third conductive pattern 1220, a first scan line GWL1, the second horizontal initialization voltage line HVAL2, and the third horizontal initialization voltage line HVAL3. The second conductive pattern 1210, the third conductive pattern 1220, the first scan line GWL1, the second horizontal initialization voltage line HVAL2, and the third horizontal initialization voltage line HVAL3 may be arranged to be spaced apart from each other.

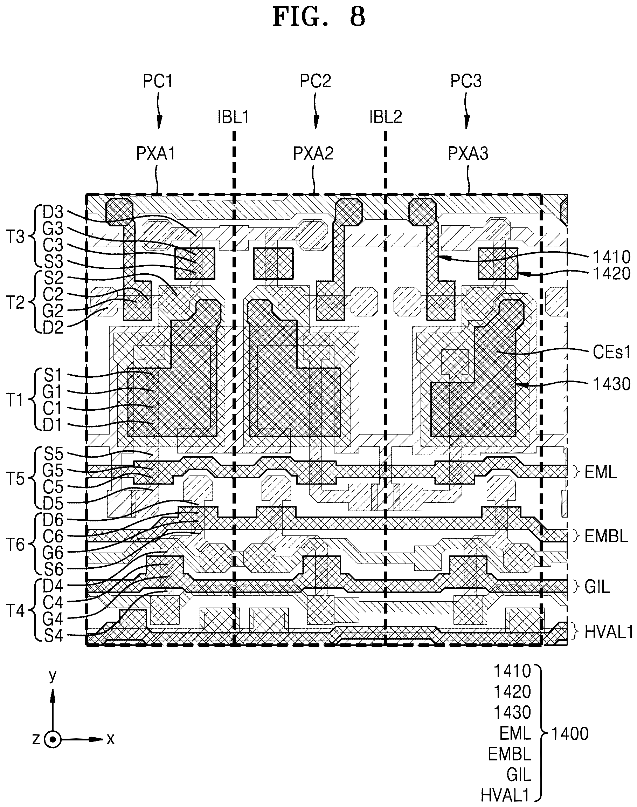

The first scan line GWL1 may extend in the first direction (e.g., the x-axis direction) to pass through the first sub-pixel circuit PC1, the second sub-pixel circuit PC2, and the third sub-pixel circuit PC3. The first scan line GWL1 may pass through the sub-pixel circuits arranged in the same row as the first sub-pixel circuit PC1, the second sub-pixel circuit PC2, and the third sub-pixel circuit PC3. The first scan line GWL1 may overlap a second scan line GWL2 (refer to FIG. 9) to be described below in a plan view. The first scan line GWL1 may be electrically connected to the second scan line GWL2 (refer to FIG. 9) and a fourth conductive pattern 1410 (refer to FIG. 8) and transmit a scan signal to the sub-pixel circuits arranged in the same row.

Each of the second horizontal initialization voltage line HVAL2 and the third horizontal initialization voltage line HVAL3 may extend in the first direction (e.g., the x-axis direction) to pass through the first sub-pixel circuit PC1, the second sub-pixel circuit PC2, and the third sub-pixel circuit PC3. The second horizontal initialization voltage line HVAL2 may be electrically connected to a second vertical initialization voltage line VVAL2 (refer to FIG. 14A) to be described below and transmit an initialization voltage to a plurality of second sub-pixel circuits PC2 arranged in the same row. The third horizontal initialization voltage line HVAL3 may be electrically connected to a third vertical initialization voltage line VVAL3 (refer to FIG. 10) to be described below and transmit an initialization voltage to a plurality of third sub-pixel circuits PC3 arranged in the same row.

The second conductive pattern 1210 may have an isolated shape in a plan view. The second conductive pattern 1210 may include a second-1 conductive pattern 1211 arranged in the first sub-pixel circuit area PXA1, a second-2 conductive pattern 1212 arranged in the second sub-pixel circuit area PXA2, and a second-3 conductive pattern 1213 arranged in the third sub-pixel circuit area PXA3. The second-1 conductive pattern 1211, the second-2 conductive pattern 1212, and the second-3 conductive pattern 1213 may be arranged to be spaced apart from each other. Each of the second-1 conductive pattern 1211 and the second-3 conductive pattern 1213 may have a quadrangular shape including a portion in which the right side thereof protrudes, and the second-2 conductive pattern 1212 may have a quadrangular shape including a portion in which the left side thereof protrudes.

Each of the second-1 conductive pattern 1211, the second-2 conductive pattern 1212, and the second-3 conductive pattern 1213 may partially overlap the first conductive pattern 1110 (refer to FIG. 5). Some areas of the second-1 conductive pattern 1211, the second-2 conductive pattern 1212, and the second-3 conductive pattern 1213, which overlap the first conductive pattern 1110 (refer to FIG. 5) in a plan view, may be the second hold electrode CEh2 of the hold capacitor Chd (refer to FIG. 3). Each of the second-1 conductive pattern 1211, the second-2 conductive pattern 1212, and the second-3 conductive pattern 1213 may partially overlap a sixth conductive pattern 1430 (refer to FIG. 8). Some areas of the second-1 conductive pattern 1211, the second-2 conductive pattern 1212, and the second-3 conductive pattern 1213, which overlap the sixth conductive pattern 1430 (refer to FIG. 8), may be the second storage electrode CEs2 of the storage capacitor Cst (refer to FIG. 3).

The third conductive pattern 1220 may be arranged in each of the first sub-pixel circuit PC1, the second sub-pixel circuit PC2, and the third sub-pixel circuit PC3. The third conductive pattern 1220 may have an isolated shape in a plan view. The third conductive pattern 1220 may have a quadrangular shape in a plan view. The third conductive pattern 1220 may be arranged to overlap the repair line RPL (refer to FIG. 5). As described above, when a particular sub-pixel circuit is defective, the light-emitting diode LED may be separated and/or disconnected from the defective sub-pixel circuit, and the light-emitting diode LED may be connected to a dummy circuit through the repair line RPL (refer to FIG. 5). When a repair process is performed, the third conductive pattern 1220 may electrically connect the repair line RPL (refer to FIG. 5) to the light-emitting diode LED together with a thirteenth conductive pattern 1570 (refer to FIG. 9).

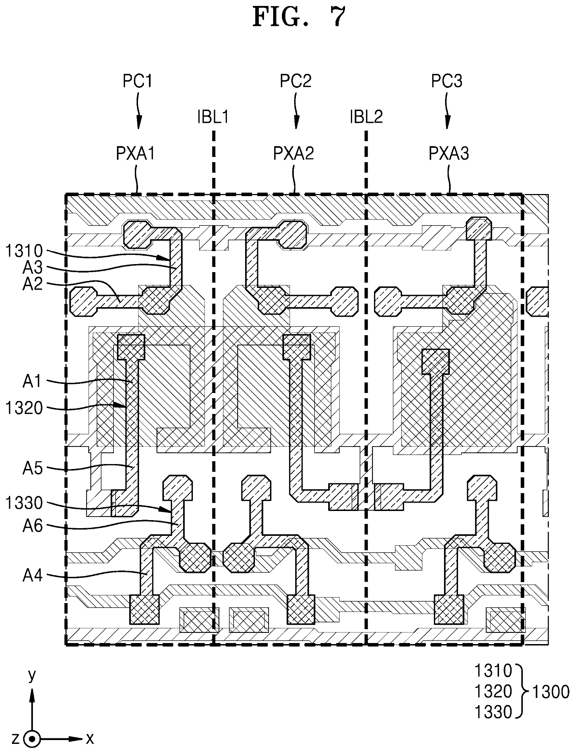

Referring to FIG. 7, a semiconductor layer 1300 may be disposed on the second lower metal layer 1200. In one or more embodiments, the semiconductor layer 1300 may include an oxide semiconductor. For example, the semiconductor layer 1300 may include an oxide semiconductor including at least one element selected from a group consisting of indium (In), gallium (Ga), tin (Sn), zirconium (Zr), vanadium (V), hafnium (Hf), cadmium (Cd), germanium (Ge), chromium (Cr), titanium (Ti), Al) cesium (Cs), cerium (Ce), and zinc (Zn). For example, the semiconductor layer 1300 may include InSnZnO (ITZO) or InGaZnO (IGZO).

The semiconductor layer 1300 may include a first semiconductor pattern 1310, a second semiconductor pattern 1320, and a third semiconductor pattern 1330. The first semiconductor pattern 1310, the second semiconductor pattern 1320, and the third semiconductor pattern 1330 may be arranged to be spaced apart from each other.

The first semiconductor pattern 1310 may be arranged in each of the first sub-pixel circuit PC1, the second sub-pixel circuit PC2, and the third sub-pixel circuit PC3. The first semiconductor pattern 1310 may have a bent shape. For example, the first semiconductor pattern 1310 may have a shape of 'the letter L' or a shape of the inverted 'letter L'. The first semiconductor pattern 1310 in the first sub-pixel circuit PC1 and the first semiconductor pattern 1310 in the second sub-pixel circuit (PC2) may be arranged symmetrically with respect to each other along the virtual line IBL1. For example, the first semiconductor pattern 1310 in the first sub-pixel circuit (PC1) may form an "L" shape, while the first semiconductor pattern 1310 in the second sub-pixel circuit (PC2) forms an inverted "L" shape, when viewed from the same viewpoint. The first semiconductor pattern 1310 may include a second semiconductor layer A2 of the second transistor T2 (refer to FIG. 4) and a third semiconductor layer A3 of the third transistor T3 (refer to FIG. 4). The second semiconductor layer A2 and the third semiconductor layer A3 may be connected as an integral body.

A portion of the first semiconductor pattern 1310 may overlap a fourth conductive pattern 1410 (refer to FIG. 8) electrically connected to the first scan line GWL1. A partial area of the first semiconductor pattern 1310, which overlaps the fourth conductive pattern 1410 (refer to FIG. 8), may be the second semiconductor layer A2. A portion of the first semiconductor pattern 1310 may overlap a fifth conductive pattern 1420 (refer to FIG. 8) electrically connected to a reference gate line GRL (refer to FIG. 9). A partial area of the first semiconductor pattern 1310, which overlaps the fifth conductive pattern 1420 (refer to FIG. 8), may be the third semiconductor layer A3.

The second semiconductor pattern 1320 may be arranged in each of the first sub-pixel circuit PC1, the second sub-pixel circuit PC2, and the third sub-pixel circuit PC3. The second semiconductor pattern 1320 may have a shape of 'the letter I' (i.e. upper-case 'i') extending in the second direction (e.g., the y-axis direction). The second semiconductor pattern 1320 may include a first semiconductor layer A1 of the first transistor T1 (refer to FIG. 4) and a fifth semiconductor layer A5 of the fifth transistor T5 (refer to FIG. 4). The first semiconductor layer A1 and the fifth semiconductor layer A5 may be connected as an integral body.

A portion of the second semiconductor pattern 1320 may overlap a sixth conductive pattern 1430 (refer to FIG. 8). A partial area of the second semiconductor pattern 1320, which overlaps the sixth conductive pattern 1430 (refer to FIG. 8), may be the first semiconductor layer A1. A portion of the second semiconductor pattern 1320 may overlap a first emission control line EML (refer to FIG. 8). A partial area of the second semiconductor pattern 1320, which overlaps the first emission control line EML (refer to FIG. 8), may be the fifth semiconductor layer A5.

The third semiconductor pattern 1330 may be arranged in each of the first sub-pixel circuit PC1, the second sub-pixel circuit PC2, and the third sub-pixel circuit PC3. The third semiconductor pattern 1330 may have a shape that is bent several times. The third semiconductor pattern 1330 may include a fourth semiconductor layer A4 of the fourth transistor T4 (refer to FIG. 4) and a sixth semiconductor layer A6 of the sixth transistor T6 (refer to FIG. 4). The fourth semiconductor layer A4 and the sixth semiconductor layer A6 may be connected as an integral body.

A portion of the third semiconductor pattern 1330 may overlap an initialization gate line GIL (refer to FIG. 8). A partial area of the third semiconductor pattern 1330, which overlaps the initialization gate line GIL (refer to FIG. 8), may be the fourth semiconductor layer A4. A portion of the third semiconductor pattern 1330 may overlap a second emission control line EMBL (refer to FIG. 8). A partial area of the third semiconductor pattern 1330, which overlaps the second emission control line EMBL (refer to FIG. 8), may be the sixth semiconductor layer A6.

Referring to FIG. 8, a first conductive layer 1400 may be disposed on the semiconductor layer 1300. The first conductive layer 1400 may include Al, Pt, Pd, Ag, Mg, Au, Ni, Nd, Ir, Cr, Li, Ca, Mo, Ti, W, and/or Cu, and may include a single layer or a multi-layer, each including the above material.

The first conductive layer 1400 may include the fourth conductive pattern 1410, the fifth conductive pattern 1420, the sixth conductive pattern 1430, the first emission control line EML, the second emission control line EMBL, the initialization gate line GIL, and the first horizontal initialization voltage line HVAL1. The fourth conductive pattern 1410, the fifth conductive pattern 1420, the sixth conductive pattern 1430, the first emission control line EML, the second emission control line EMBL, the initialization gate line GIL, and the first horizontal initialization voltage line HVAL1 may be arranged to be spaced apart from each other.

The fourth conductive pattern 1410 may be arranged in each of the first sub-pixel circuit PC1, the second sub-pixel circuit PC2, and the third sub-pixel circuit PC3. The fourth conductive pattern 1410 may have an isolated shape in a plan view. The fourth conductive pattern 1410 may have a shape of 'the letter I' (i.e. upper-case 'i') extending slightly in the second direction (e.g., the y-axis direction). One end of the fourth conductive pattern 1410 may overlap the first scan line GWL1 (refer to FIG. 6) and a second scan line GWL2 (refer to FIG. 9) in a plan view, and may be electrically connected to the second scan line GWL2 (refer to FIG. 9) to receive a scan signal. Another end of the fourth conductive pattern 1410 may overlap the first semiconductor pattern 1310.

The fourth conductive pattern 1410 may include a second gate electrode G2 of the second transistor T2. A portion of the fourth conductive pattern 1410 may overlap the second semiconductor layer A2 (refer to FIG. 7) of the second transistor T2, and the overlapped portion of the fourth conductive pattern 1410 may correspond to the second gate electrode G2. The second semiconductor layer A2 (refer to FIG. 7) of the second transistor T2 may include a channel area C2 overlapping the fourth conductive pattern 1410, and doped areas S2 and D2 respectively arranged on both sides of the channel area C2 and doped with impurities. One of the doped areas S2 and D2 may be a source area, and the other one may be a drain area. The source area and the drain area may correspond to a source electrode and a drain electrode, respectively. The positions of the source area and the drain area may be interchanged depending on the properties of a transistor.

The fifth conductive pattern 1420 may be arranged in each of the first sub-pixel circuit PC1, the second sub-pixel circuit PC2, and the third sub-pixel circuit PC3. The fifth conductive pattern 1420 may have an isolated shape in a plan view. The fifth conductive pattern 1420 may have a quadrangular shape in a plan view. The fifth conductive pattern 1420 may be electrically connected to a reference gate line GRL (refer to FIG. 9) to be described below to receive a reference signal.

The fifth conductive pattern 1420 may include a third gate electrode G3 of the third transistor T3. A portion of the fifth conductive pattern 1420 may overlap the third semiconductor layer A3 (refer to FIG. 7) of the third transistor T3, and the overlapped portion of the fifth conductive pattern 1420 may correspond to the third gate electrode G3. The third semiconductor layer A3 (refer to FIG. 7) of the third transistor T3 may include a channel area C3 overlapping the fifth conductive pattern 1420, and doped areas S3 and D3 respectively arranged on both sides of the channel area C3 and doped with impurities. One of the doped areas S3 and D3 may be a source area, and the other one may be a drain area. The source area and the drain area may correspond to a source electrode and a drain electrode, respectively. The positions of the source area and the drain area may be interchanged depending on the properties of a transistor.

The sixth conductive pattern 1430 may be arranged in each of the first sub-pixel circuit PC1, the second sub-pixel circuit PC2, and the third sub-pixel circuit PC3. The sixth conductive pattern 1430 may have an isolated shape in a plan view. The sixth conductive pattern 1430 may have a thick 'letter L' shape or a quadrangular shape with a protruding upper side.

The sixth conductive pattern 1430 may include a first gate electrode G1 of the first transistor T1. A portion of the sixth conductive pattern 1430 may overlap the first semiconductor layer A1 (refer to FIG. 7) of the first transistor T1, and the overlapped portion of the sixth conductive pattern 1430 may correspond to the first gate electrode G1. Here, the first gate electrode G1 may be the upper gate electrode Ga (refer to FIG. 3) described above in FIG. 3, and the lower gate electrode Gb (refer to FIG. 3) described above in FIG. 3 may be a partial area included in the second conductive pattern 1210 (refer to FIG. 6). The first semiconductor layer A1 (refer to FIG. 7) of the first transistor T1 may include a channel area C1 overlapping the sixth conductive pattern 1430, and doped areas S1 and D1 respectively arranged on both sides of the channel area C1 and doped with impurities. One of the doped areas S1 and D1 may be a source area, and the other one may be a drain area. The source area and the drain area may correspond to a source electrode and a drain electrode, respectively. The positions of the source area and the drain area may be interchanged depending on the properties of a transistor.

The sixth conductive pattern 1430 may partially overlap the second conductive pattern 1210 (refer to FIG. 6). A partial area of the sixth conductive pattern 1430, which overlaps the second conductive pattern 1210 (refer to FIG. 6) in a plan view, may be the first storage electrode CEs1 of the storage capacitor Cst (refer to FIG. 4).

The first emission control line EML may extend in the first direction (e.g., the x-axis direction) to pass through the first sub-pixel circuit PC1, the second sub-pixel circuit PC2, and the third sub-pixel circuit PC3. The first emission control line EML may pass through the sub-pixel circuits arranged in the same row as the first sub-pixel circuit PC1, the second sub-pixel circuit PC2, and the third sub-pixel circuit PC3.

The first emission control line EML may include a fifth gate electrode G5 of the fifth transistor T5. A portion of the first emission control line EML may overlap the fifth semiconductor layer A5 (refer to FIG. 7) of the fifth transistor T5, and the overlapped portion of the first emission control line EML may correspond to the fifth gate electrode G5. The fifth semiconductor layer A5 (refer to FIG. 7) of the fifth transistor T5 may include a channel area C5 overlapping the first emission control line EML, and doped areas S5 and D5 respectively arranged on both sides of the channel area C5 and doped with impurities. One of the doped areas S5 and D5 may be a source area, and the other one may be a drain area. The source area and the drain area may correspond to a source electrode and a drain electrode, respectively. The positions of the source area and the drain area may be interchanged depending on the properties of a transistor.

The second emission control line EMBL may extend in the first direction (e.g., the x-axis direction) to pass through the first sub-pixel circuit PC1, the second sub-pixel circuit PC2, and the third sub-pixel circuit PC3. The second emission control line EMBL may pass through the sub-pixel circuits arranged in the same row as the first sub-pixel circuit PC1, the second sub-pixel circuit PC2, and the third sub-pixel circuit PC3.

The second emission control line EMBL may include a sixth gate electrode G6 of the sixth transistor T6. A portion of the second emission control line EMBL may overlap the sixth semiconductor layer A6 (refer to FIG. 7) of the sixth transistor T6, and the overlapped portion of the second emission control line EMBL may correspond to the sixth gate electrode G6. The sixth semiconductor layer A6 (refer to FIG. 7) of the sixth transistor T6 may include a channel area C6 overlapping the second emission control line EMBL, and doped areas S6 and D6 respectively arranged on both sides of the channel area C6 and doped with impurities. One of the doped areas S6 and D6 may be a source area, and the other one may be a drain area. The source area and the drain area may correspond to a source electrode and a drain electrode, respectively. The positions of the source area and the drain area may be interchanged depending on the properties of a transistor.

The initialization gate line GIL may extend in the first direction (e.g., the x-axis direction) to pass through the first sub-pixel circuit PC1, the second sub-pixel circuit PC2, and the third sub-pixel circuit PC3. The initialization gate line GIL may pass through the sub-pixel circuits arranged in the same row as the first sub-pixel circuit PC1, the second sub-pixel circuit PC2, and the third sub-pixel circuit PC3.

The initialization gate line GIL may include a fourth gate electrode G4 of the fourth transistor T4. A portion of the initialization gate line GIL may overlap the fourth semiconductor layer A4 (refer to FIG. 7) of the fourth transistor T4, and the overlapped portion of the initialization gate line GIL may correspond to the fourth gate electrode G4. The fourth semiconductor layer A4 (refer to FIG. 7) of the fourth transistor T4 may include a channel area C4 overlapping the initialization gate line GIL, and doped areas S4 and D4 respectively arranged on both sides of the channel area C4 and doped with impurities. One of the doped areas S4 and D4 may be a source area, and the other one may be a drain area. The source area and the drain area may correspond to a source electrode and a drain electrode, respectively. The positions of the source area and the drain area may be interchanged depending on the properties of a transistor.

The first horizontal initialization voltage line HVAL1 may extend in the first direction (e.g., the x-axis direction) to pass through the first sub-pixel circuit PC1, the second sub-pixel circuit PC2, and the third sub-pixel circuit PC3. The first horizontal initialization voltage line HVAL1 may be electrically connected to a first vertical initialization voltage line VVAL1 (refer to FIG. 14A) to be described below and transmit an initialization voltage to a plurality of first sub-pixel circuits PC1 arranged in the same row.

Referring to FIG. 9, a second conductive layer 1500 may be disposed on the first conductive layer 1400. The second conductive layer 1500 may include Al, Pt, Pd, Ag, Mg, Au, Ni, Nd, Ir, Cr, Li, Ca, Mo, Ti, W, and/or Cu, and may include a single layer or a multi-layer, each including the above material.

The second conductive layer 1500 may include a seventh conductive pattern 1510, an eighth conductive pattern 1520, a ninth conductive pattern 1530, a tenth conductive pattern 1540, an eleventh conductive pattern 1550, a twelfth conductive pattern 1560, a thirteenth conductive pattern 1570, the second scan line GWL2, and the reference gate line GRL. The seventh conductive pattern 1510, the eighth conductive pattern 1520, the ninth conductive pattern 1530, the tenth conductive pattern 1540, the eleventh conductive pattern 1550, the twelfth conductive pattern 1560, the thirteenth conductive pattern 1570, the second scan line GWL2, and the reference gate line GRL may be arranged to be spaced apart from each other.

The second scan line GWL2 may extend in the first direction (e.g., the x-axis direction) to pass through the first sub-pixel circuit PC1, the second sub-pixel circuit PC2, and the third sub-pixel circuit PC3. The second scan line GWL2 may pass through the sub-pixel circuits arranged in the same row as the first sub-pixel circuit PC1, the second sub-pixel circuit PC2, and the third sub-pixel circuit PC3. The second scan line GWL2 may overlap the first scan line GWL1 (refer to FIG. 6) in a plan view. The second scan line GWL2 may be electrically connected to the first scan line GWL1 (refer to FIG. 6) and the fourth conductive pattern 1410 (refer to FIG. 8) and transmit a scan signal to the sub-pixel circuits arranged in the same row. In particular, the second scan line GWL2 may be electrically connected to the first scan line GWL1 through a second contact hole CNT2, and may be electrically connected to the fourth conductive pattern 1410 (refer to FIG. 8) through a first contact hole CNT1.

The seventh conductive pattern 1510 may include a seventh-1 conductive pattern 1511 arranged across the first sub-pixel circuit area PXA1 and the second sub-pixel circuit area PXA2, and a seventh-2 conductive pattern 1512 arranged in the third sub-pixel circuit area PXA3. The seventh-1 conductive pattern 1511 may have a shape that is symmetrical with respect to the virtual line IBL1, and may have a lying 'letter I' (i.e. upper-case 'i') shape extending in the first direction (e.g., the x-axis direction). The seventh-2 conductive pattern 1512 may have a shape that slightly extends in the first direction (e.g., the x-axis direction). The seventh conductive pattern 1510 may be electrically connected to the horizontal reference voltage line HVRL (refer to FIG. 5) to transmit a reference voltage to the third transistor T3 (refer to FIG. 4). In particular, the seventh-1 conductive pattern 1511 may be electrically connected to the horizontal reference voltage line HVRL through a fourth-1 contact hole CNT4a, and may be electrically connected to the first semiconductor pattern 1310 of the first sub-pixel circuit PC1 and the first semiconductor pattern 1310 of the second sub-pixel circuit PC2 through a third-1 contact hole CNT3a and a third-2 contact hole CNT3b, respectively. The seventh-2 conductive pattern 1512 may be electrically connected to the horizontal reference voltage line HVRL through a fourth-2 contact hole CNT4b, and may be electrically connected to the first semiconductor pattern 1310 of the third sub-pixel circuit PC3 through a third-3 contact hole CNT3c.

The reference gate line GRL may extend in the first direction (e.g., the x-axis direction) to pass through the first sub-pixel circuit PC1, the second sub-pixel circuit PC2, and the third sub-pixel circuit PC3. The reference gate line GRL may pass through the sub-pixel circuits arranged in the same row as the first sub-pixel circuit PC1, the second sub-pixel circuit PC2, and the third sub-pixel circuit PC3. The reference gate line GRL may be electrically connected to the fifth conductive pattern 1420 (refer to FIG. 8) including the third gate electrode G3 (refer to FIG. 8) of the third transistor T3 (refer to FIG. 8) to transmit a reference signal to the third gate electrode G3 (refer to FIG. 8). In particular, the reference gate line GRL may be electrically connected to the fifth conductive pattern 1420 (refer to FIG. 8) through a fifth contact hole CNT5.

The eighth conductive pattern 1520 may be arranged in each of the first sub-pixel circuit PC1, the second sub-pixel circuit PC2, and the third sub-pixel circuit PC3. The eighth conductive pattern 1520 may have an isolated shape in a plan view. The eighth conductive pattern 1520 may have a quadrangular shape with rounded corners in a plan view. The eighth conductive pattern 1520 may be electrically connected to a data line DL (refer to FIG. 10) to be described below to transmit a data signal to the second transistor T2 (refer to FIG. 8). In particular, the eighth conductive pattern 1520 may overlap the data line DL (refer to FIG. 10) in a plan view to be electrically connected to the data line DL (refer to FIG. 10), and may be electrically connected to the first semiconductor pattern 1310 (refer to FIG. 7) through a sixth contact hole CNT6.

The ninth conductive pattern 1530 may be arranged in each of the first sub-pixel circuit PC1, the second sub-pixel circuit PC2, and the third sub-pixel circuit PC3. The ninth conductive pattern 1530 may have an isolated shape in a plan view. The ninth conductive pattern 1530 may have a shape that slightly extends in the first direction (e.g., the x-axis direction). The ninth conductive pattern 1530 may electrically connect the second semiconductor layer A2 (refer to FIG. 7) of the second transistor T2 (refer to FIG. 8) and the third semiconductor layer A3 (refer to FIG. 7) of the third transistor T3 (refer to FIG. 8) to the first gate electrode G1 (refer to FIG. 8) of the first transistor T1 (refer to FIG. 8). That is, the ninth conductive pattern 1530 may correspond to the first node N1 (refer to FIG. 3) described with reference to FIG. 3, and may also be referred to as a first node electrode. In particular, the ninth conductive pattern 1530 may be electrically connected to the first semiconductor pattern 1310 (refer to FIG. 7) through a seventh contact hole CNT7, and may be electrically connected to the sixth conductive pattern 1430 (refer to FIG. 8) through an eighth contact hole CNT8.

The tenth conductive pattern 1540 may be arranged in each of the first sub-pixel circuit PC1, the second sub-pixel circuit PC2, and the third sub-pixel circuit PC3. The tenth conductive pattern 1540 may have an isolated shape in a plan view. The tenth conductive pattern 1540 may have a roughly quadrangular shape in a plan view, but may further include a protruding portion protruding toward the lower side. The tenth conductive pattern 1540 may electrically connect the first semiconductor layer A1 (refer to FIG. 7) of the first transistor T1 (refer to FIG. 8), the second storage electrode CEs2 (refer to FIG. 6) of the storage capacitor Cst (refer to FIG. 4), the second hold electrode CEh2 (refer to FIG. 6) of the hold capacitor Chd (refer to FIG. 4), and the sixth semiconductor layer A6 (refer to FIG. 7) of the sixth transistor T6 (refer to FIG. 8) to each other. That is, the tenth conductive pattern 1540 may correspond to the second node N2 (refer to FIG. 3) described with reference to FIG. 3, and may also be referred to as a second node electrode. In particular, the tenth conductive pattern 1540 may be electrically connected to the second conductive pattern 1210 (refer to FIG. 6) through a ninth contact hole CNT9, may be electrically connected to the second semiconductor pattern 1320 (refer to FIG. 7) through a tenth contact hole CNT10, and may be electrically connected to the third semiconductor pattern 1330 (refer to FIG. 7) through an eleventh contact hole CNT11.

The eleventh conductive pattern 1550 may include an eleventh-1 conductive pattern 1551 arranged in the first sub-pixel circuit area PXA1 and an eleventh-2 conductive pattern 1552 arranged across the second sub-pixel circuit area PXA2 and the third sub-pixel circuit area PXA3. Each of the eleventh-1 conductive pattern 1551 and the eleventh-2 conductive pattern 1552 may have an isolated shape in a plan view. The eleventh-1 conductive pattern 1551 may have a quadrangular shape in a plan view, and the eleventh-2 conductive pattern 1552 may have a shape extending in the first direction (e.g., the x-axis direction). The eleventh conductive pattern 1550 may be electrically connected to a lower driving voltage line LPL (refer to FIG. 10) and an upper driving voltage line UPL (refer to FIG. 11) to transmit a driving voltage to the fifth semiconductor layer A5 (refer to FIG. 7) of the fifth transistor T5 (refer to FIG. 4) and the first hold electrode CEh1 (refer to FIG. 5) of the hold capacitor Chd (refer to FIG. 4). In particular, the eleventh-1 conductive pattern 1551 may be electrically connected to the lower driving voltage line LPL (refer to FIG. 10) to be described below, may be electrically connected to the first conductive pattern 1110 (refer to FIG. 5) through a twelfth-1 contact hole CNT12a, and may be electrically connected to the second semiconductor pattern 1320 (refer to FIG. 7) of the first sub-pixel circuit PC1 through a thirteenth-1 contact hole CNT13a. Similarly, the eleventh-2 conductive pattern 1552 may be electrically connected to the upper driving voltage line UPL (refer to FIG. 11) to be described below, and may be electrically connected to the first conductive pattern 1110 (refer to FIG. 5) through a twelfth-2 contact hole CNT12b. The eleventh-2 conductive pattern 1552 may be electrically connected to the second semiconductor pattern 1320 (refer to FIG. 7) of the second sub-pixel circuit PC2 through a thirteenth-2 contact hole CNT13b, and may be electrically connected to the second semiconductor pattern 1320 (refer to FIG. 7) of the third sub-pixel circuit PC3 through a thirteenth-3 contact hole CNT13c.

The twelfth conductive pattern 1560 may be arranged in each of the first sub-pixel circuit PC1, the second sub-pixel circuit PC2, and the third sub-pixel circuit PC3. The twelfth conductive pattern 1560 may include a twelfth-1 conductive pattern 1561 arranged within the first sub-pixel circuit area PXA1, a twelfth-2 conductive pattern 1562 arranged within the second sub-pixel circuit area PXA2, and a twelfth-3 conductive pattern 1563 arranged within the third sub-pixel circuit area PXA3. Each of the twelfth-1 conductive pattern 1561, the twelfth-2 conductive pattern 1562, and the twelfth-3 conductive pattern 1563 may have an isolated shape. Each of the twelfth-1 conductive pattern 1561 and the twelfth-2 conductive pattern 1562 may have a shape that slightly extends in the first direction (e.g., the x-axis direction) in a plan view, and the twelfth-3 conductive pattern 1563 may have a shape extending in the second direction (e.g., the y-axis direction) and being bent once. The twelfth conductive pattern 1560 may connect the initialization voltage line VAL (refer to FIG. 4) to the fourth semiconductor layer A4 (refer to FIG. 7) of the fourth transistor T4 (Refer to FIG. 4).

In particular, the twelfth-1 conductive pattern 1561 may be electrically connected to the first horizontal initialization voltage line HVAL1 through a fourteenth-1 contact hole CNT14a, and may be electrically connected to the third semiconductor pattern 1330 (refer to FIG. 7) of the first sub-pixel circuit PC1 through a fifteenth-1 contact hole CNT15a to transmit a first initialization voltage to the fourth transistor T4 (refer to FIG. 4) of the first sub-pixel circuit PC1. The twelfth-2 conductive pattern 1562 may be electrically connected to the second horizontal initialization voltage line HVAL2 (refer to FIG. 6) through a fourteenth-2 contact hole CNT14b, and may be electrically connected to the third semiconductor pattern 1330 (refer to FIG. 7) of the second sub-pixel circuit PC2 through a fifteenth-2 contact hole CNT15b to transmit a second initialization voltage to the fourth transistor T4 (refer to FIG. 4) of the second sub-pixel circuit PC2. The twelfth-3 conductive pattern 1563 may be electrically connected to the third horizontal initialization voltage line HVAL3 (refer to FIG. 6) through a fourteenth-3 contact hole CNT14c, and may be electrically connected to the third semiconductor pattern 1330 (refer to FIG. 7) of the third sub-pixel circuit PC3 through a fifteenth-3 contact hole CNT15c to transmit a third initialization voltage to the fourth transistor T4 (refer to FIG. 4) of the third sub-pixel circuit PC3.

The thirteenth conductive pattern 1570 may be arranged in each of the first sub-pixel circuit PC1, the second sub-pixel circuit PC2, and the third sub-pixel circuit PC3. The thirteenth conductive pattern 1570 may include a thirteenth-1 conductive pattern 1571 arranged within the first sub-pixel circuit area PXA1, a thirteenth-2 conductive pattern 1572 arranged within the second sub-pixel circuit area PXA2, and a thirteenth-3 conductive pattern 1573 arranged within the third sub-pixel circuit area PXA3. Each of the thirteenth-1 conductive pattern 1571, the thirteenth-2 conductive pattern 1572, and the thirteenth-3 conductive pattern 1573 may have an isolated shape. Each of the thirteenth-1 conductive pattern 1571, the thirteenth-2 conductive pattern 1572, and the thirteenth-3 conductive pattern 1573 may have a shape that slightly extends in the second direction (e.g., the y-axis direction).

The thirteenth conductive pattern 1570 may electrically connect the fourth transistor T4 (refer to FIG. 4) and the sixth transistor T6 (refer to FIG. 6) to the light-emitting diode LED (refer to FIG. 3). In particular, the thirteenth conductive pattern 1570 may be electrically connected to the third semiconductor pattern 1330 (refer to FIG. 7) through a sixteenth contact hole CNT16, and may be electrically connected to the light-emitting diode LED (refer to FIG. 3) through a fifteenth conductive pattern 1620 (refer to FIG. 10) and a seventeenth conductive pattern 1710 (Refer to FIG. 11), which will be described below.

One end of the thirteenth conductive pattern 1570 may be electrically connected to the third conductive pattern 1220 (refer to FIG. 6) through a seventeenth contact hole CNT17. As described above, the third conductive pattern 1220 (refer to FIG. 6) may be electrically connected to the repair line RPL through a repair process. When a sub-pixel circuit is defective, the light-emitting diode LED may be disconnected from the third semiconductor pattern 1330 (refer to FIG. 7), and the thirteenth conductive pattern 1570 may be electrically connected to the repair line RPL (refer to FIG. 5).

Referring to FIG. 10, a third conductive layer 1600 may be disposed on the second conductive layer 1500. The third conductive layer 1600 may include Al, Pt, Pd, Ag, Mg, Au, Ni, Nd, Ir, Cr, Li, Ca, Mo, Ti, W, and/or Cu, and may include a single layer or a multi-layer, each including the above material.

The third conductive layer 1600 may include a fourteenth conductive pattern 1610, a fifteenth conductive pattern 1620, a sixteenth conductive pattern 1630, a data line DL, a lower driving voltage line LPL, and a third vertical initialization voltage line VVAL3. The fourteenth conductive pattern 1610, the fifteenth conductive pattern 1620, the sixteenth conductive pattern 1630, the data line DL, the lower driving voltage line LPL, and the third vertical initialization voltage line VVAL3 may be arranged to be spaced apart from each other.

The fourteenth conductive pattern 1610 may be arranged in each of the first sub-pixel circuit PC1, the second sub-pixel circuit PC2, and the third sub-pixel circuit PC3. The fourteenth conductive pattern 1610 may have an isolated shape in a plan view. The fourteenth conductive pattern 1610 may have a quadrangular shape in a plan view, but may further include a protruding portion protruding toward the lower side. The fourteenth conductive pattern 1610 may be electrically connected to the tenth conductive pattern 1540 (refer to FIG. 9) through a nineteenth contact hole CNT19, and may have a shape covering the ninth conductive pattern 1530 (refer to FIG. 9). As the fourteenth conductive pattern 1610 shields the ninth conductive pattern 1530 (refer to FIG. 9) connected to the storage capacitor Cst (refer to FIG. 4), the image quality characteristics may be improved.

The fifteenth conductive pattern 1620 may be arranged in each of the first sub-pixel circuit PC1, the second sub-pixel circuit PC2, and the third sub-pixel circuit PC3. The fifteenth conductive pattern 1620 may include a fifteenth-1 conductive pattern 1621 arranged within the first sub-pixel circuit area PXA1, a fifteenth-2 conductive pattern 1622 arranged within the second sub-pixel circuit area PXA2, and a fifteenth-3 conductive pattern 1623 arranged within the third sub-pixel circuit area PXA3. Each of the fifteenth-1 conductive pattern 1621, the fifteenth-2 conductive pattern 1622, and the fifteenth-3 conductive pattern 1623 may have an isolated shape. Each of the fifteenth-1 conductive pattern 1621, the fifteenth-2 conductive pattern 1622, and the fifteenth-3 conductive pattern 1623 may have a shape that slightly extends in the second direction (y-axis direction).

The fifteenth conductive pattern 1620 may connect the fourth transistor T4 (refer to FIG. 8) and the sixth transistor T6 (refer to FIG. 8) to the light-emitting diode LED through the thirteenth conductive pattern 1570 and a seventeenth conductive pattern 1710 (refer to FIG. 11) to be described below. In particular, one end of the fifteenth conductive pattern 1620 may be electrically connected to the thirteenth conductive pattern 1570 (refer to FIG. 9) through a twenty-first contact hole CNT21, and another end of the fifteenth conductive pattern 1620 may be electrically connected to the seventeenth conductive pattern 1710 (refer to FIG. 11) through a contact hole.

The sixteenth conductive pattern 1630 may be arranged in at least one of the first sub-pixel circuit PC1, the second sub-pixel circuit PC2, and the third sub-pixel circuit PC3. For example, as shown in FIG. 10, the sixteenth conductive pattern 1630 may be arranged within the third sub-pixel circuit area PXA3. The sixteenth conductive pattern 1630 may receive a driving voltage from an upper driving voltage line UPL (refer to FIG. 11) to transmit the driving voltage to the fifth semiconductor layer A5 (refer to FIG. 7) of the second sub-pixel circuit PC2 and the fifth semiconductor layer A5 (refer to FIG. 7) of the third sub-pixel circuit PC3. In particular, the sixteenth conductive pattern 1630 may be electrically connected to a second upper driving voltage line UPL2 (refer to FIG. 11) to be described below, and may be electrically connected to the eleventh-2 conductive pattern 1552 (refer to FIG. 9) through a twenty-second contact hole CNT22.

The data line DL may extend in the second direction (e.g., the y-axis direction). The data line DL may include the first data line DL1 electrically connected to the first sub-pixel circuit PC1, the second data line DL2 electrically connected to the second sub-pixel circuit PC2, and the third data line DL3 electrically connected to the third sub-pixel circuit PC3. The data line DL may be electrically connected to the eighth conductive pattern 1520 (refer to FIG. 9) connected to the first semiconductor pattern 1310 (refer to FIG. 7) through an eighteenth contact hole CNT18. That is, the data line DL may transmit a data signal to the second semiconductor layer A2 (refer to FIG. 7) through the eighth conductive pattern 1520 (refer to FIG. 9).

The first data line DL1 may be arranged to pass through the first sub-pixel circuit area PXA1, the second data line DL2 may be arranged to pass through the second sub-pixel circuit area PXA2, and the third data line DL3 may be arranged to pass through the third sub-pixel circuit area PXA3. The first data line DL1 may be arranged on the left side of the first lower driving voltage line LPL1. The second data line DL2 and the third data line DL3 may be arranged in parallel between the second lower driving voltage line LPL2 and the third vertical initialization voltage line VVAL3.

The third vertical initialization voltage line VVAL3 may extend in the second direction (e.g., the y-axis direction). The third vertical initialization voltage line VVAL3 may be electrically connected to the third horizontal initialization voltage line HVAL3 (refer to FIG. 6) to transmit a third initialization voltage to the fourth transistor T4 (refer to FIG. 4) of the third sub-pixel circuit PC3. Although not shown in FIG. 10, the third conductive layer 1600 may further include a first vertical initialization voltage line VVAL1 and a second vertical initialization voltage line VVAL2. The first vertical initialization voltage line VVAL1 (refer to FIG. 14A) may be electrically connected to the first horizontal initialization voltage line HVAL1 (refer to FIG. 8) to transmit a first initialization voltage to the fourth transistor T4 (refer to FIG. 4) of the first sub-pixel circuit PC1. The second vertical initialization voltage line VVAL2 (refer to FIG. 14A) may be electrically connected to the second horizontal initialization voltage line HVAL2 (refer to FIG. 6) to transmit a second initialization voltage to the fourth transistor T4 (refer to FIG. 4) of the second sub-pixel circuit PC2.

The lower driving voltage line LPL may extend in the second direction (e.g., the y-axis direction). The lower driving voltage line LPL may include the first lower driving voltage line LPL1 arranged within the first sub-pixel circuit area PXA1 and the second lower driving voltage line LPL2 arranged within the second sub-pixel circuit area PXA2. The lower driving voltage line LPL may be electrically connected to an upper driving voltage line UPL (refer to FIG. 11) to be described below. That is, the vertical driving voltage line VPL (refer to FIG. 4) arranged within the display area DA (refer to FIG. 2) may have a double-layered structure. The driving voltage line PL (refer to FIG. 4) is described in detail below with reference to FIGS. 13A to 14C.

In one or more embodiments, the first lower driving voltage line LPL1 and the second lower driving voltage line LPL2 may be connected as an integral body. For example, as shown in FIG. 10, the first lower driving voltage line LPL1 and the second lower driving voltage line LPL2 may be connected to each other through a horizontal portion LPh. The first lower driving voltage line LPL1 may be electrically connected to the eleventh-1 conductive pattern 1551 (refer to FIG. 9) through the twentieth contact hole CNT20. As described above, the eleventh-1 conductive pattern 1551 (refer to FIG. 9) may be electrically connected to the first hold electrode CEh1 (refer to FIG. 5) and the fifth semiconductor layer A5 (refer to FIG. 7) of the fifth transistor T5 (refer to FIG. 4). Accordingly, the first lower driving voltage line LPL1 and the second lower driving voltage line LPL2 may transmit a driving voltage to the first conductive pattern 1110 (refer to FIG. 5) and a second semiconductor pattern 1320 (refer to FIG. 7) through the eleventh-1 conductive pattern 1551 (refer to FIG. 9).

Referring to FIG. 11, a fourth conductive layer 1700 may be disposed on the third conductive layer 1600. The fourth conductive layer 1700 may include Al, Pt, Pd, Ag, Mg, Au, Ni, Nd, Ir, Cr, Li, Ca, Mo, Ti, W, and/or Cu, and may include a single layer or a multi-layer, each including the above material.

The fourth conductive layer 1700 may include a seventeenth conductive pattern 1710, the upper driving voltage line UPL, and an upper common voltage line UVS. The seventeenth conductive pattern 1710, the upper driving voltage line UPL, and the upper common voltage line UVS may be arranged to be spaced apart from each other.

The seventeenth conductive pattern 1710 may be arranged in each of the first sub-pixel circuit PC1, the second sub-pixel circuit PC2, and the third sub-pixel circuit PC3. The seventeenth conductive pattern 1710 may include a seventeenth-1 conductive pattern 1711 arranged within the first sub-pixel circuit area PXA1, a seventeenth-2 conductive pattern 1712 arranged within the second sub-pixel circuit area PXA2, and a seventeenth-3 conductive pattern 1713 arranged within the third sub-pixel circuit area PXA3. Each of the seventeenth-1 conductive pattern 1711, the seventeenth-2 conductive pattern 1712, and the seventeenth-3 conductive pattern 1713 may have an isolated shape. Each of the seventeenth-1 conductive pattern 1711, the seventeenth-2 conductive pattern 1712, and the seventeenth-3 conductive pattern 1713 may have a shape that slightly extends in the second direction (e.g., the y-axis direction).

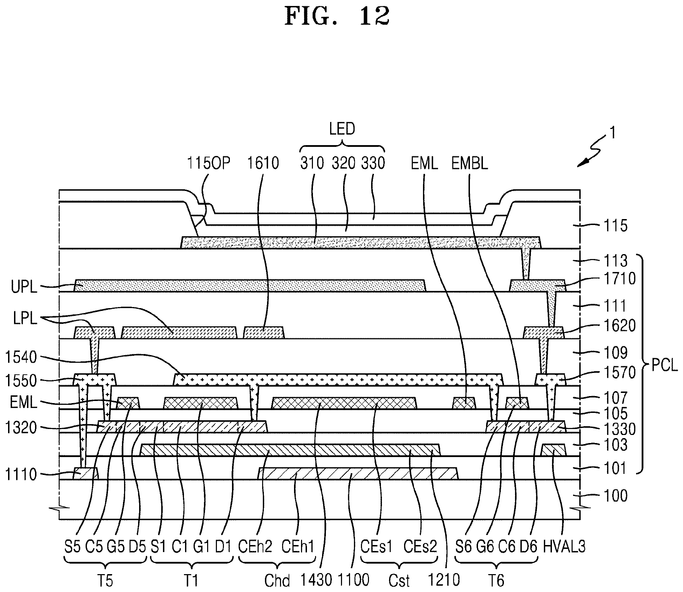

The seventeenth conductive pattern 1710 may be a connection electrode that electrically connects the sub-pixel circuit PC (refer to FIG. 3) to the light-emitting diode LED (refer to FIG. 3). In particular, the seventeenth conductive pattern 1710 may be electrically connected to the fifteenth conductive pattern 1620 (refer to FIG. 10) through a twenty-fourth contact hole CNT24, and may be electrically connected to a pixel electrode 310 (refer to FIG. 12) of a light-emitting diode LED (refer to FIG. 12) through a twenty-fifth contact hole CNT25. As described above, the fifteenth conductive pattern 1620 (refer to FIG. 10) may be connected to the third semiconductor pattern 1330 (refer to FIG. 7) through the thirteenth conductive pattern 1570 (refer to FIG. 9). That is, the third semiconductor pattern 1330 (refer to FIG. 7) including the fourth semiconductor layer A4 (refer to FIG. 7) and the sixth semiconductor layer A6 (refer to FIG. 7) may be electrically connected to the light-emitting diode LED (refer to FIG. 12) through the fifteenth conductive pattern 1620 (refer to FIG. 10) and the seventeenth conductive pattern 1710.

The upper driving voltage line UPL may extend in the second direction (e.g., the y-axis direction). The upper driving voltage line UPL may include the first upper driving voltage line UPL1 arranged across the first sub-pixel circuit area PXA1 and the second sub-pixel circuit area PXA2, and the second upper driving voltage line UPL2 arranged in the third sub-pixel circuit area PXA3. The upper driving voltage line UPL may be electrically connected to the lower driving voltage line LPL. That is, the vertical driving voltage line VPL (refer to FIG. 4) arranged within the display area DA (refer to FIG. 2) may have a double-layered structure. The upper driving voltage line UPL and the lower driving voltage line LPL may be connected to the driving voltage supply line 15 (refer to FIG. 2) to transmit a driving voltage to a plurality of sub-pixel circuits. The double-layered structure of the driving voltage line PL (refer to FIG. 4) is described in detail below with reference to FIGS. 13A to 14C.

The first upper driving voltage line UPL1 may be electrically connected to the first lower driving voltage line (refer to FIG. 10) through a twenty-third-1 contact hole CNT23a, and the second upper driving voltage line UPL2 may be electrically connected to the sixteenth conductive pattern 1630 (refer to FIG. 10) through a twenty-third-2 contact hole CNT23b.

In one or more embodiments, the first upper driving voltage line UPL1 and the second upper driving voltage line UPL2 may have different shapes. First, the second upper driving voltage line UPL2 may only have a shape extending in the second direction (e.g., the y-axis direction) except for a protruding portion where the twenty-third-2 contact hole CNT23b is arranged. Conversely, the first upper driving voltage line UPL1 may have a mesh structure in a partial area. The mesh structure of the first upper driving voltage line UPL1 may have a grid-like arrangement of vertical conductive portions, such as UPm1 and UPm2, with gaps or interruptions, such as the disconnection between first sub-vertical portion UPs1 and the vertical conductive portions. In particular, the first upper driving voltage line UPL1 may include a first main vertical portion UPm1 arranged in the first sub-pixel circuit area PXA1 and extending in the second direction (e.g., the y-axis direction) and a second main vertical portion UPm2 arranged in the second sub-pixel circuit area PXA2 and extending in the second direction (e.g., the y-axis direction). The first upper driving voltage line UPL1 may further include a first sub-vertical portion UPs1 arranged between the first main vertical portion UPm1 and the second main vertical portion UPm2 and extending in the second direction (e.g., the y-axis direction). The first sub-vertical portion UPs1 may be disconnected by the seventeenth conductive pattern 1710, unlike the first main vertical portion UPm1 and the second main vertical portion UPm2.

At this time, the first main vertical portion UPm1, the second main vertical portion UPm2, and the first sub-vertical portion UPs1 may be connected as an integral body. This may be to lower the resistance of the first upper driving voltage line UPL1. The first main vertical portion UPm1, the second main vertical portion UPm2, and the first sub-vertical portion UPs1 may be connected by a first horizontal portion UPh1 and a second horizontal portion UPh2. The positions of the first horizontal portion UPh1 and the second horizontal portion UPh2 may be designed differently depending on an arrangement of the light-emitting diode LED and may not be limited to FIG. 11. However, the positions of the first horizontal portion UPh1 and the second horizontal portion UPh2 may be arranged so that there is no height deviation of the surrounding structures of an opening 115OP (refer to FIG. 12) of a bank layer 115 (refer to FIG. 12), which defines an emission area.

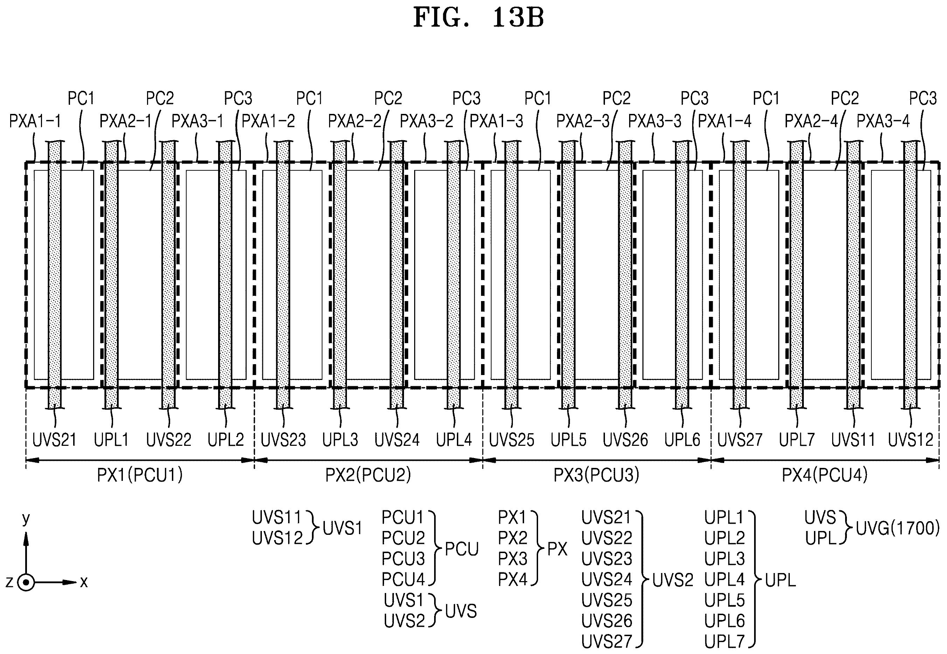

The common voltage line VSL (refer to FIG. 4) may include a horizontal common voltage line HVSL (refer to FIG. 14C) and the vertical common voltage line VVSL, as described above. The vertical common voltage line VVSL may extend in the second direction (e.g., the y-axis direction). Although it will be described below with reference to FIGS. 13A and 13B, the vertical common voltage line VVSL may have a double-layered structure. The vertical common voltage line VVSL may include a lower common voltage line LVS (refer to FIG. 13A) disposed below the third conductive layer 1600 (refer to FIG. 10) and the upper common voltage line UVS disposed on the fourth conductive layer 1700. At this time, the upper common voltage line UVS may include a first upper common voltage line UVS1 (refer to FIG. 13B), which is not shown in FIG. 11, and a second upper common voltage line UVS2. Although it will be described below, the first upper common voltage line UVS1 (refer to FIG. 13B) may be a line configured to transmit a common voltage to an opposite electrode 330 (refer to FIG. 12) of the light-emitting diode LED (refer to FIG. 12) within the display area DA (refer to FIG. 2), and the second upper common voltage line UVS2 may be a line configured to transmit a common voltage to the opposite electrode 330 (refer to FIG. 12) within the peripheral area PA (refer to FIG. 2). The second upper common voltage line UVS2 may include the second-1 upper common voltage line UVS21 arranged within the first sub-pixel circuit area PXA1 and the second-2 upper common voltage line UVS22 arranged across the second sub-pixel circuit area PXA2 and the third sub-pixel circuit area PXA3.

The upper common voltage line UVS may overlap the data line DL (refer to FIG. 10) disposed on the third conductive layer 1600 (refer to FIG. 10) in a plan view. In other words, the upper common voltage line UVS may shield the data line DL (refer to FIG. 10) from external light. For example, the second-1 upper common voltage line UVS21 may shield the first data line DL1 (refer to FIG. 10), and the second-2 upper common voltage line UVS22 may shield the second data line DL2 (refer to FIG. 10) and the third data line DL3 (refer to FIG. 10).

FIG. 12 is a schematic cross-sectional view of a portion of the display apparatus 1 according to one or more embodiments.

Referring to FIG. 12, the display apparatus 1 may include a pixel circuit layer PCL including transistors and capacitors disposed on the substrate 100 and a display element layer disposed on the pixel circuit layer PCL described above and including the light-emitting diode LED. The pixel circuit layer PCL may include the transistors and capacitors described above with reference to FIGS. 4 to 11, and FIG. 12 shows the first transistor T1, the fifth transistor T5, the sixth transistor T6, the storage capacitor Cst, and the hold capacitor Chd.

The substrate 100 may include a glass material, a ceramic material, a metal material, plastic, or a flexible or bendable material. When the substrate 100 is flexible or bendable, the substrate 100 may include a polymer resin such as polyethersulfone (PES), polyacrylate, polyetherimide (PEI), polyethylene naphthalate (PEN), polyethylene terephthalate (PET), polyphenylene sulfide (PPS), polyarylate, polyimide (PI), polycarbonate, and cellulose acetate propionate (CAP), or the like.

The substrate 100 may have a single-layered structure or a multi-layered structure, and may further include an inorganic layer in the case of a multi-layered structure. For example, the substrate 100 may have a structure in which a layer including the above polymer resin and a barrier layer including an inorganic insulating material are alternately stacked.

The first lower metal layer 1100 (refer to FIG. 5) may be disposed on the substrate 100. The first lower metal layer 1100 (refer to FIG. 5) may include at least one material selected from among Al, Pt, Pd, Ag, Mg, Au, Ni, Nd, Ir, Cr, Li, Ca, Mo, Ti, W, and Cu, as described above.

The first lower metal layer 1100 (refer to FIG. 5) may include the first conductive pattern 1110. The first conductive pattern 1110 may partially overlap the second conductive pattern 1210 to be described below to form the hold capacitor Chd. A partial area of the first conductive pattern 1110, which overlaps the second conductive pattern 1210 in a plan view, may be the first hold electrode CEh1.

A first buffer layer 101 may be disposed on the first conductive pattern 1110. The first buffer layer 101 may be an inorganic insulating layer including an inorganic insulating material such as silicon nitride and/or silicon oxide, and may have a single-layered structure or a multi-layered structure, each including the above material.

A second lower metal layer 1200 (refer to FIG. 6) may be disposed on the first buffer layer 101. The second lower metal layer 1200 (refer to FIG. 6) may include at least one material selected from among Al, Pt, Pd, Ag, Mg, Au, Ni, Nd, Ir, Cr, Li, Ca, Mo, Ti, W, and Cu, as described above.

The second lower metal layer 1200 (refer to FIG. 6) may include the second conductive pattern 1210 and the third horizontal initialization voltage line HVAL3. The second conductive pattern 1210 may partially overlap the first conductive pattern 1110 to form the hold capacitor Chd. A partial area of the second conductive pattern 1210, which overlaps the first conductive pattern 1110 in a plan view, may be the second hold electrode CEh2. In addition, the second conductive pattern 1210 may partially overlap the sixth conductive pattern 1430 to be described below to form the storage capacitor Cst. A partial area of the second conductive pattern 1210, which overlaps the sixth conductive pattern 1430 in a plan view, may be the second storage electrode CEs2. The second conductive pattern 1210 may be arranged to partially overlap the first transistor T1. The second conductive pattern 1210 may shield light traveling toward the semiconductor layer of the first transistor T1 and protect the first transistor T1 from static electricity.

A second buffer layer 103 may be disposed on the second conductive pattern 1210. The second buffer layer 103 may be an inorganic insulating layer including an inorganic insulating material such as silicon nitride and/or silicon oxide, and may have a single-layered structure or a multi-layered structure, each including the above material.

The semiconductor layer 1300 (refer to FIG. 7) may be disposed on the second buffer layer 103. The semiconductor layer 1300 (refer to FIG. 7) may include an oxide semiconductor, and the oxide semiconductor may include an oxide semiconductor including at least one element selected from a group consisting of In, Ga, Sn, Zr, V, Hf, Cd, Ge, Cr, Ti, Al, Cs, Ce, and Zn. For example, the oxide semiconductor may include ITZO or IGZO.

Referring to FIG. 12, the second semiconductor pattern 1320 and the third semiconductor pattern 1330 may be disposed on the second buffer layer 103. The second semiconductor pattern 1320 may include the fifth semiconductor layer A5 (refer to FIG. 7) of the fifth transistor T5 and the first semiconductor layer A1 (refer to FIG. 7) of the first transistor T1, and the third semiconductor pattern 1330 may include the sixth semiconductor layer A6 (refer to FIG. 7) of the sixth transistor T6. The first semiconductor layer A1 may include the channel area C1 and the doped areas S1 and D1 respectively arranged on both sides of the channel area C1. Any one of the doped areas S1 and D1 may be a source, and the other one may be a drain. The fifth semiconductor layer A5 may include the channel area C5 and the doped areas S5 and D5 respectively arranged on both sides of the channel area C5. Any one of the doped areas S5 and D5 may be a source, and the other one may be a drain. The sixth semiconductor layer A6 may include the channel area C6 and the doped areas S6 and D6 respectively arranged on both sides of the channel area C6. Any one of the doped areas S6 and D6 may be a source, and the other one may be a drain.

A gate insulating layer 105 may be disposed on the second semiconductor pattern 1320 and the third semiconductor pattern 1330. The gate insulating layer 105 may be an inorganic insulating layer including an inorganic insulating material such as silicon oxide, silicon nitride, and/or silicon oxynitride, and may have a single-layered structure or a multi-layered structure, each including the above material.

The first conductive layer 1400 (refer to FIG. 8) may be disposed on the gate insulating layer 105. The first conductive layer 1400 (refer to FIG. 8) may include at least one material selected from among Al, Pt, Pd, Ag, Mg, Au, Ni, Nd, Ir, Cr, Li, Ca, Mo, Ti, W, and Cu, as described above.

The first conductive layer 1400 (refer to FIG. 8) may include the first emission control line EML, the sixth conductive pattern 1430, and the second emission control line EMBL. The sixth conductive pattern 1430 may include the first gate electrode G1 of the first transistor T1. The first gate electrode G1 may be disposed on the gate insulating layer 105, and may overlap the channel area C1 of the first transistor T1. In addition, a portion of the sixth conductive pattern 1430 may overlap the second conductive pattern 1210 to form the storage capacitor Cst. A partial area of the sixth conductive pattern 1430, which overlaps the second conductive pattern 1210 in a plan view, may be the first storage electrode CEs1.

An interlayer insulating layer 107 may be disposed on the first emission control line EML, the second emission control line EMBL, and the sixth conductive pattern 1430. The interlayer insulating layer 107 may be an inorganic insulating layer including an inorganic insulating material such as silicon oxide, silicon nitride, and/or silicon oxynitride, and may have a single-layered structure or a multi-layered structure, each including the above material.

The second conductive layer 1500 (refer to FIG. 9) may be disposed on the interlayer insulating layer 107. The second conductive layer 1500 (refer to FIG. 9) may include at least one material selected from among Al, Pt, Pd, Ag, Mg, Au, Ni, Nd, Ir, Cr, Li, Ca, Mo, Ti, W, and Cu, as described above.

The second conductive layer 1500 (refer to FIG. 9) may include the tenth conductive pattern 1540, the eleventh conductive pattern 1550, and the thirteenth conductive pattern 1570. The tenth conductive pattern 1540 may be a connection electrode connecting the second semiconductor pattern 1320 to the third semiconductor pattern 1330. That is, the tenth conductive pattern 1540 is a connection electrode connecting the first semiconductor layer A1 (refer to FIG. 7) of the first transistor T1 to the sixth semiconductor layer A6 (refer to FIG. 7) of the sixth transistor T6, which may also be referred to as a second node electrode. The eleventh conductive pattern 1550 may be a connection electrode connecting the second semiconductor pattern 1320 to the lower driving voltage line LPL. That is, the eleventh conductive pattern 1550 may receive a driving voltage from the lower driving voltage line LPL and transmit the driving voltage to the fifth semiconductor layer A5 (refer to FIG. 7) of the fifth transistor T5. The thirteenth conductive pattern 1570 may be a connection electrode connecting the third semiconductor pattern 1330 to a pixel electrode 310 of the light-emitting diode LED.

A first planarization layer 109 may be disposed on the tenth conductive pattern 1540, the eleventh conductive pattern 1550, and the thirteenth conductive pattern 1570. The first planarization layer 109 may include an organic insulating material, such as acrylic, benzocyclobutene (BCB), PI, hexamethyldisiloxane (HMDSO), or the like. In some embodiments, the first planarization layer 109 may also include an inorganic insulating material.

The third conductive layer 1600 (refer to FIG. 10) may be disposed on the first planarization layer 109. The third conductive layer 1600 (refer to FIG. 10) may include at least one material selected from among Al, Pt, Pd, Ag, Mg, Au, Ni, Nd, Ir, Cr, Li, Ca, Mo, Ti, W, and Cu, as described above.

The third conductive layer 1600 (refer to FIG. 10) may include the lower driving voltage line LPL, the fourteenth conductive pattern 1610, and the fifteenth conductive pattern 1620. Although not shown in FIG. 12, the lower driving voltage line LPL may be electrically connected to the upper driving voltage line UPL and may transmit a driving voltage to the second semiconductor pattern 1320 and the first conductive pattern 1110 through the eleventh conductive pattern 1550. The fifteenth conductive pattern 1620 may be a connection electrode connecting the third semiconductor pattern 1330 to the pixel electrode 310 of the light-emitting diode LED.

A second planarization layer 111 may be disposed on the lower driving voltage line LPL, the fourteenth conductive pattern 1610, and the fifteenth conductive pattern 1620. The second planarization layer 111 may include an organic insulating material, such as acrylic, BCB, PI, or HMDSO. In some embodiments, the second planarization layer 111 may also include an inorganic insulating material.

The fourth conductive layer 1700 (refer to FIG. 11) may be disposed on the second planarization layer 111. The fourth conductive layer 1700 (refer to FIG. 11) may include at least one material selected from among Al, Pt, Pd, Ag, Mg, Au, Ni, Nd, Ir, Cr, Li, Ca, Mo, Ti, W, and Cu, as described above.

The fourth conductive layer 1700 (refer to FIG. 11) may include the upper driving voltage line UPL and the seventeenth conductive pattern 1710. Although not shown in FIG. 12, the upper driving voltage line UPL may be electrically connected to the lower driving voltage line LPL to transmit a driving voltage to a sub-pixel circuit. The seventeenth conductive pattern 1710 may be a connection electrode connecting the third semiconductor pattern 1330 to the pixel electrode 310 of the light-emitting diode LED, together with the thirteenth conductive pattern 1570 and the fifteenth conductive pattern 1620.

A third planarization layer 113 may be disposed on the upper driving voltage line UPL and the seventeenth conductive pattern 1710. The third planarization layer 113 may include an organic insulating material, such as acrylic, BCB, PI, or HMDSO. In some embodiments, the third planarization layer 113 may also include an inorganic insulating material.

The light-emitting diode LED may be disposed on the third planarization layer 113. The light-emitting diode LED may include the pixel electrode 310 on the third planarization layer 113, an intermediate layer 320, and the opposite electrode 330.

An outer portion of the pixel electrode 310 may be covered with a bank layer 115, and an inner portion of the pixel electrode 310 may overlap the intermediate layer 320 through an opening 115OP of the bank layer 115. The pixel electrode 310 may be arranged to correspond to each light-emitting diode LED, and the opposite electrode 330 may be arranged to correspond to a plurality of light-emitting diodes LED. In other words, the opposite electrode 330 may extend to overlap a plurality of pixel electrodes 310. The plurality of light-emitting diodes LED may share the opposite electrode 330, and a stacked structure of the pixel electrode 310, the intermediate layer 320, and the opposite electrode 330 may correspond to the light-emitting diode LED.

The intermediate layer 320 may include an emission layer. In some embodiments, the intermediate layer 320 may further include an emission layer and a functional layer. The functional layer may include a hole transport layer (HTL), a hole injection layer (HIL), an electron transport layer (ETL), and/or an electron injection layer (EIL). In some other embodiments, the intermediate layer 320 may include a first stack including an emission layer and a functional layer, a second stack including an emission layer and a functional layer, and a charge generation layer between the first stack and the second stack. The charge generation layer may include a negative charge generation layer and a positive charge generation layer. The emission efficiency of the light-emitting diode LED, which is a tandem light-emitting type having a plurality of emission layers, may be further increased by the negative charge generation layer and the positive charge generation layer.

The negative charge generation layer may be an n-type charge generation layer. The negative charge generation layer may supply electrons. The negative charge generation layer may include a host and a dopant. The host may include an organic material. The dopant may include a metal material. The positive charge generation layer may be a p-type charge generation layer. The positive charge generation layer may supply holes. The positive charge generation layer may include a host and a dopant. The host may include an organic material. The dopant may include a metal material.

The opposite electrode 330 may include a conductive material having a low work function. The opposite electrode 330 may include a (semi)transparent layer including Ag, Mg, Al, Pt, Pd, Au, Ni, Nd, Ir, Cr, Li, Ca, alloys thereof, or the like. Alternatively, the opposite electrode 330 may further include a layer such as ITO, IZO, ZnO, or In₂O₃ above the (semi) transparent layer including the above-stated material.

Although not shown in the drawing, an encapsulation layer may be disposed on the light-emitting diode LED. The encapsulation layer may include a first inorganic encapsulation layer, a second inorganic encapsulation layer, and an organic encapsulation layer therebetween.

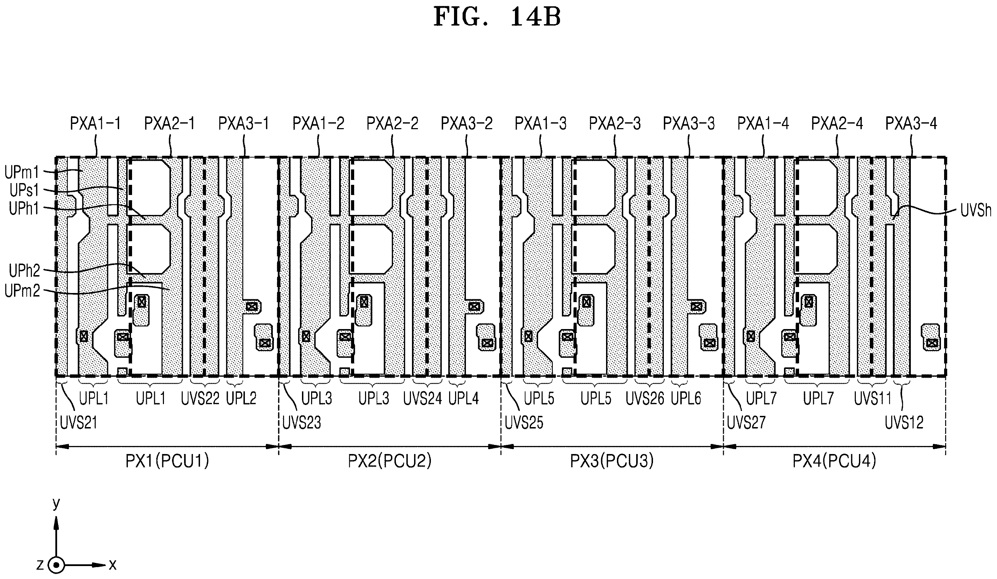

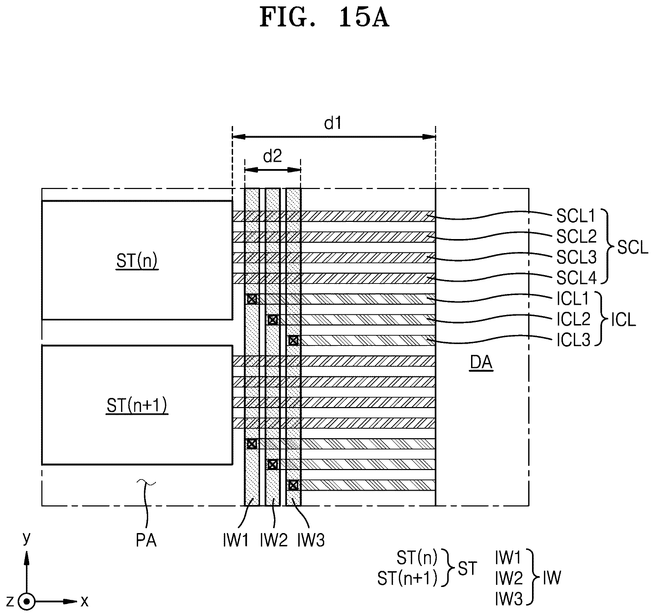

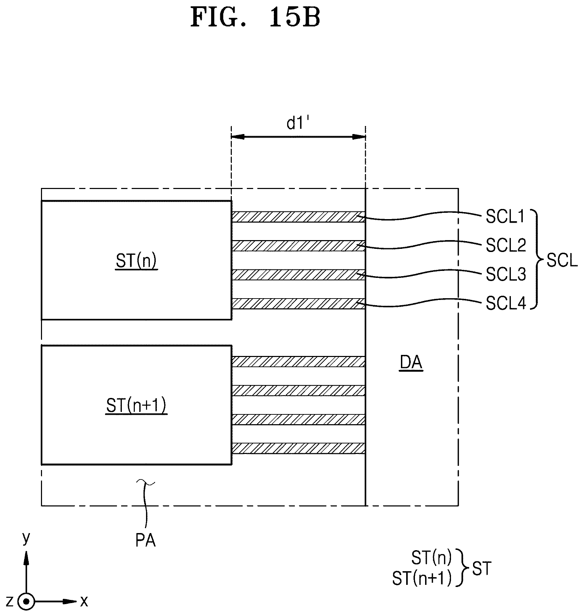

FIGS. 13A and 13B are schematic conceptual diagrams of arrangements of a plurality of voltage lines of a display apparatus according to one or more embodiments. FIGS. 14A, 14B, and 14C are schematic plan views illustrating the third conductive layer 1600, the fourth conductive layer 1700, and a first electrode layer 3100 of a display apparatus according to one or more embodiments, respectively. FIG. 15A is a schematic plan view of a portion of a peripheral area according to a comparative example, and FIG. 15B is a schematic plan view of a portion of a peripheral area of a display apparatus according to one or more embodiments.

First, referring to FIGS. 13A and 13B, one pixel PX may have three sub-pixels SPX (refer to FIG. 3). For example, the pixel PX may include a first sub-pixel, a second sub-pixel, and a third sub-pixel. Here, the first sub-pixel may include the first sub-pixel circuit PC1 and a first light-emitting diode electrically connected to the first sub-pixel circuit PC1 and emitting red light. The second sub-pixel may include the second sub-pixel circuit PC2 and a second light-emitting diode electrically connected to the second sub-pixel circuit PC2 and emitting green light. The third sub-pixel may include the third sub-pixel circuit PC3 and a third light-emitting diode electrically connected to the third sub-pixel circuit PC3 and emitting blue light.

The first sub-pixel circuit PC1 included in the first pixel PX1 may be arranged in a first-1 sub-pixel circuit area PXA1-1, the second sub-pixel circuit PC2 included in the first pixel PX1 may be arranged in a second-1 sub-pixel circuit area PXA2-1, and the third sub-pixel circuit PC3 included in the first pixel PX1 may be arranged in the third-1 sub-pixel circuit area PXA3-1. Here, the first-1 sub-pixel circuit area PXA1-1, the second-1 sub-pixel circuit area PXA2-1, and the third-1 sub-pixel circuit area PXA3-1 may be respectively referred to as the first sub-pixel circuit area PXA1, the second sub-pixel circuit area PXA2, and the third sub-pixel circuit area PXA3 shown in FIGS. 4 to 11. The first sub-pixel circuit PC1, the second sub-pixel circuit PC2, and the third sub-pixel circuit PC3 included in the first pixel PX1 may configure a first sub-pixel circuit unit PCU1.

A first sub-pixel circuit PC1 included in a second pixel PX2 may be arranged in a first-2 sub-pixel circuit area PXA1-2, a second sub-pixel circuit PC2 included in the second pixel PX2 may be arranged in a second-2 sub-pixel circuit area PXA2-2, and a third sub-pixel circuit PC3 included in the second pixel PX2 may be arranged in a third-2 sub-pixel circuit area PXA3-2. The first sub-pixel circuit PC1, the second sub-pixel circuit PC2, and the third sub-pixel circuit PC3 included in the second pixel PX2 may configure a second sub-pixel circuit unit PCU2.

A first sub-pixel circuit PC1 included in a third pixel PX3 may be arranged in a first-3 sub-pixel circuit area PXA1-3, a second sub-pixel circuit PC2 included in the third pixel PX3 may be arranged in a second-3 sub-pixel circuit area PXA2-3, and a third sub-pixel circuit PC3 included in the third pixel PX3 may be arranged in a third-3 sub-pixel circuit area PXA3-3. The first sub-pixel circuit PC1, the second sub-pixel circuit PC2, and the third sub-pixel circuit PC3 included in the third pixel PX3 may configure a third sub-pixel circuit unit PCU3.

A first sub-pixel circuit PC1 included in a fourth pixel PX4 may be arranged in a first-4 sub-pixel circuit area PXA1-4, a second sub-pixel circuit PC2 included in the fourth pixel PX4 may be arranged in a second-4 sub-pixel circuit area PXA2-4, and a third sub-pixel circuit PC3 included in the fourth pixel PX4 may be arranged in a third-4 sub-pixel circuit area PXA3-4. The first sub-pixel circuit PC1, the second sub-pixel circuit PC2, and the third sub-pixel circuit PC3 included in the fourth pixel PX4 may configure a fourth sub-pixel circuit unit PCU4.

Referring to FIGS. 13A and 14A, the third conductive layer 1600 may include a lower voltage line group LVG including a plurality of voltage lines. The lower voltage line group LVG may include a lower driving voltage line LPL, a vertical initialization voltage line VVAL, a vertical reference voltage line VVRL, and a lower common voltage line LVS. The lower driving voltage line LPL is a line electrically connected to an upper driving voltage line UPL (refer to FIG. 13B) and configured to transmit a driving voltage, which may include a first lower driving voltage line LPL1, a second lower driving voltage line LPL2, a third lower driving voltage line LPL3, and a fourth lower driving voltage line LPL4. The vertical initialization voltage line VVAL may include a first vertical initialization voltage line VVAL1 configured to transmit a first initialization voltage to the first sub-pixel circuit PC1, a second vertical initialization voltage line VVAL2 configured to transmit a second initialization voltage to the second sub-pixel circuit PC2, and a third vertical initialization voltage line VVAL3 configured to transmit a third initialization voltage to the third sub-pixel circuit PC3.

In one or more embodiments, in the case of the third conductive layer 1600, three vertical voltage lines may be disposed on one sub-pixel circuit unit PCU. For example, the first lower driving voltage line LPL1, the second lower driving voltage line LPL2, and a third-1 vertical initialization voltage line VVAL3a may be disposed on the first sub-pixel circuit unit PCU1. FIG. 13A shows that the first lower driving voltage line LPL1 is arranged within the first-1 sub-pixel circuit area PXA1-1, the second lower driving voltage line LPL2 is arranged in the second-1 sub-pixel circuit area PXA2-1, and the third-1 vertical initialization voltage line VVAL3a is arranged in the third-1 sub-pixel circuit area PXA3-1, but the disclosure is not limited thereto. Each of the voltage lines may be freely disposed on the first sub-pixel circuit unit PCU1.

Similarly, a first-1 vertical initialization voltage line VVAL1a, a second-1 vertical initialization voltage line VVAL2a, and the vertical reference voltage line VVRL may be disposed on the second sub-pixel circuit unit PCU2. A third lower driving voltage line LPL3, a fourth lower driving voltage line LPL4, and a third-2 vertical initialization voltage line VVAL3b may be disposed on the third sub-pixel circuit unit PCU3. A first-2 vertical initialization voltage line VVAL1b, a second-2 initialization voltage line VVAL2b, and the lower common voltage line LVS may be disposed on the fourth sub-pixel circuit unit PCU4.

To summarize, the lower voltage line group LVG may include twelve voltage lines respectively disposed on the first to fourth sub-pixel circuit units PCU1, PCU2, PCU3, and PCU4. The lower voltage line group LVG within the display area DA (refer to FIG. 2) may be repeatedly arranged in the first direction (e.g., the x-axis direction). That is, a plurality of voltage lines disposed on the third conductive layer 1600 may be repeatedly arranged in a cycle (or unit) of the lower voltage line group LVG disposed on the first to fourth sub-pixel circuit units PCU1, PCU2, PCU3, and PCU4.

In one or more embodiments, two lower driving voltage lines LPL may be arranged per two pixels PX. For example, as shown in FIG. 13A, the first lower driving voltage line LPL1 and the second lower driving voltage line LPL2 may be disposed on the first sub-pixel circuit unit PCU1 and the second sub-pixel circuit unit PCU2, and the third lower driving voltage line LPL3 and the fourth lower driving voltage line LPL4 may be disposed on the third sub-pixel circuit unit PCU3 and the fourth sub-pixel circuit unit PCU4. In one or more embodiments, the lower driving voltage lines LPL arranged adjacent to each other may be connected as an integral body. For example, as shown in FIG. 14A, the first lower driving voltage line LPL1 and the second lower driving voltage line LPL2 may be connected as an integral body through the horizontal portion LPh. This may be to lower the resistance of the lower driving voltage line LPL.

In one or more embodiments, each of the first vertical initialization voltage line VVAL1, the second vertical initialization voltage line VVAL2, and the third vertical initialization voltage line VVAL3 may be arranged per two pixels PX. For example, as shown in FIG. 13A, the first-1 vertical initialization voltage line VVAL1a, the second-1 vertical initialization voltage line VVAL2a, and the third-1 vertical initialization voltage line VVAL3a may be disposed on the first sub-pixel circuit unit PCU1 and the second sub-pixel circuit unit PCU2, and the first-2 vertical initialization voltage line VVAL1b, the second-2 vertical initialization voltage line VVAL2b, the third-2 vertical initialization voltage line VVAL3b may be disposed on the third sub-pixel circuit unit PCU3 and the fourth sub-pixel circuit unit PCU4.

The first-1 vertical initialization voltage line VVAL1a and the first-2 vertical initialization voltage line VVAL1b may each be electrically connected to the first horizontal initialization voltage line HVAL1 (refer to FIG. 8) to form a mesh structure. Similarly, the second-1 vertical initialization voltage line VVAL2a and the second-2 vertical initialization voltage line VVAL2b may each be electrically connected to the second horizontal initialization voltage line HVAL2 (refer to FIG. 6) to form a mesh structure. The third-1 vertical initialization voltage line VVAL3a and the third-2 vertical initialization voltage line VVAL3b may each be electrically connected to the third horizontal initialization voltage line HVAL3 (refer to FIG. 6) to form a mesh structure.

In one or more embodiments, the vertical reference voltage line VVRL may be arranged per four pixels PX. For example, as shown in FIG. 13A, one vertical reference voltage line VVRL may be disposed on first to fourth sub-pixel circuit units PCU1, PCU2, PCU3, and PCU4. The vertical reference voltage line VVRL may be electrically connected to the horizontal reference voltage line HVRL (refer to FIG. 5) to form a mesh structure.

In one or more embodiments, the vertical common voltage line VVSL (refer to FIG. 4) may include the lower common voltage line LVS disposed on the third conductive layer 1600 and the upper common voltage line UVS disposed on the fourth conductive layer 1700 (refer to FIG. 13B). The lower common voltage line LVS may be arranged per four pixels PX. For example, as shown in FIG. 13A, one lower common voltage line LVS may be disposed on first to fourth sub-pixel circuit units PCU1, PCU2, PCU3, and PCU4. The lower common voltage line LVS may be electrically connected to a first upper common voltage line UVS1 (refer to FIG. 13B) of the upper common voltage line UVS (refer to FIG. 13B).

Referring to FIGS. 13B and 14B, the fourth conductive layer 1700 may include an upper voltage line group UVG including a plurality of voltage lines. The upper voltage line group UVG may include the upper driving voltage line UPL and the upper common voltage line UVS. The upper driving voltage line UPL is a line electrically connected to the lower driving voltage line LPL (refer to FIG. 13A) and configured to transmit a driving voltage, which may include first to seventh upper driving voltage lines UPL1, UPL2, UPL3, UPL4, UPL5, UPL6, and UPL7.

Referring to FIG. 14C, the first electrode layer 3100 may include the pixel electrode 310 and an auxiliary electrode AE. The pixel electrode 310 may include a first pixel electrode 310R electrically connected to the first sub-pixel circuit PC1 (refer to FIG. 4), a second pixel electrode 310G electrically connected to the second sub-pixel circuit PC2 (refer to FIG. 4), and a third pixel electrode 310B electrically connected to the third sub-pixel circuit PC3 (refer to FIG. 4). As shown in FIG. 14C, the first pixel electrode 310R and the second pixel electrode 310G may be arranged in the same column in the second direction (e.g., the y-axis direction). The third pixel electrodes 310B may be arranged in a column adjacent to the columns where the first pixel electrode 310R and the second pixel electrode 310G are arranged. As described above, the pixel electrode 310 may be electrically connected to the third semiconductor pattern 1330 (refer to FIG. 7) through the thirteenth conductive pattern 1570 (refer to FIG. 9), the fifteenth conductive pattern 1620 (refer to FIG. 10), and the seventeenth conductive pattern 1710 (refer to FIG. 11).

The auxiliary electrode AE may be disposed on the same layer as the pixel electrode 310 and include the same material as the pixel electrode 310. The auxiliary electrode AE may be arranged to be spaced apart from the pixel electrode 310. The auxiliary electrode AE may include an auxiliary electrode main portion AEm and an auxiliary electrode horizontal portion AEh. The auxiliary electrode main portion AEm may be a portion in direct contact with the opposite electrode 330 (refer to FIG. 12). In addition, the auxiliary electrode main portion AEm may be electrically connected to the first upper common voltage line UVS1 (refer to FIG. 13B) through a contact hole. Accordingly, the auxiliary electrode AE may connect the first upper common voltage line UVS1 (refer to FIG. 13B) to the opposite electrode 330 (refer to FIG. 12). In addition, a plurality of auxiliary electrode main portions AEm arranged adjacent to each other may be connected as an integral body through the auxiliary electrode horizontal portion AEh. Accordingly, because the auxiliary electrode AE has a shape extending in the first direction (e.g., the x-axis direction), the auxiliary electrode AE may also be referred to as a horizontal common voltage line HVSL.

Referring to FIGS. 13B and 14B again, the upper common voltage line UVS is a line configured to transmit a common voltage to the opposite electrode 330 (refer to FIG. 12), which may include a first upper common voltage line UVS1 and a second upper common voltage line UVS2. The first upper common voltage line UVS1 may be configured to transmit a common voltage to the opposite electrode 330 (refer to FIG. 12) through the auxiliary electrode AE (refer to FIG. 14C) within the display area DA (refer to FIG. 2). The first upper common voltage line UVS1 may be electrically connected to the lower common voltage line LVS through a contact hole. That is, the lower common voltage line LVS, the first upper common voltage line UVS1, and the auxiliary electrode AE may be electrically connected to each other to form a mesh structure. The second upper common voltage line UVS2 may be configured to transmit a common voltage to the opposite electrode 330 (refer to FIG. 12) within the peripheral area PA (refer to FIG. 2). That is, unlike the first upper common voltage line UVS1, the second upper common voltage line UVS2 may not be connected to the auxiliary electrode AE through a contact hole. The first upper common voltage line UVS1 may include a first-1 upper common voltage line UVS11 and a first-2 upper common voltage line UVS12. The second upper common voltage line UVS2 may include second-1 to second-7 upper common voltage lines UVS21, UVS22, UVS23, UVS24, UVS25, UVS26, and UVS27.

In one or more embodiments, in the case of the fourth conductive layer 1700, four vertical voltage lines may be disposed on one sub-pixel circuit unit PCU. For example, the second-1 upper common voltage line UVS21, the first upper driving voltage line UPL1, the second-2 upper common voltage line UVS22, and the second upper driving voltage line UPL2 may be disposed on the first sub-pixel circuit unit PCU1. Similarly, the second-3 upper common voltage line UVS23, the third upper driving voltage line UPL3, the second-4 upper common voltage line UVS24, and the fourth upper driving voltage line UPL4 may be disposed on the second sub-pixel circuit unit PCU2.

The second-5 upper common voltage line UVS25, the fifth upper driving voltage line UPL5, the second-6 upper common voltage line UVS26, and the sixth upper driving voltage line UPL6 may be disposed on the third sub-pixel circuit unit PCU3. The second-7 upper common voltage line UVS27, the seventh upper driving voltage line UPL7, the first-1 upper common voltage line UVS11, and the first-2 upper common voltage line UVS12 may be disposed on the fourth sub-pixel circuit unit PCU4.

To summarize, the upper voltage line group UVG may include sixteen voltage lines respectively disposed on the first to fourth sub-pixel circuit units PCU1, PCU2, PCU3, and PCU4. The upper voltage line group UVG within the display area DA (refer to FIG. 2) may be repeatedly arranged in the first direction (e.g., the x-axis direction). That is, a plurality of voltage lines disposed on the fourth conductive layer 1700 may be repeatedly arranged in a cycle (or unit) of the upper voltage line group UVG disposed on the first to fourth sub-pixel circuit units PCU1, PCU2, PCU3, and PCU4.

In one or more embodiments, seven upper driving voltage lines UPL may be arranged per four pixels PX. For example, as shown in FIG. 13B, the first to seventh upper driving voltage lines UPL1, UPL2, UPL3, UPL4, UPL5, UPL6, and UPL7 may be disposed on the first to fourth sub-pixel circuit units PCU1, PCU2, PCU3, and PCU4. The first upper driving voltage line UPL1 and the fifth upper driving voltage line UPL5 may be respectively connected to the first lower driving voltage line LPL1 (refer to FIG. 14A) and the third lower driving voltage line LPL3 (refer to FIG. 14A), which are disposed therebelow, through contact holes to transmit driving voltages to a sub-pixel circuit. The second, third, fourth, sixth, and seventh upper driving voltage lines UPL2, UPL3, UPL4, UPL6, and UPL7 may be respectively connected to corresponding conductive patterns disposed therebelow through contact holes to transmit driving voltages to a sub-pixel circuit.

As described above, at least some of the first, third, fifth, and seventh upper driving voltage lines UPL1, UPL3, UPL5, and UPL7 may include a mesh structure. For example, the first upper driving voltage line UPL1 may include the first main vertical portion UPm1, the second main vertical portion UPm2, and the first sub-vertical portion UPs1, which extend in the second direction (e.g., the y-axis direction). At this time, the first main vertical portion UPm1, the second main vertical portion UPm2, and the first sub-vertical portion UPs1 may be connected as an integral body through the first horizontal portion UPh1 and the second horizontal portion UPh2. The shape of the lines as described above may be configured to optimize the outgassing open rate while reducing resistance.

In one or more embodiments, two first upper common voltage lines UVS1 may be arranged per four pixels PX. For example, as shown in FIG. 13B, the first-1 upper common voltage line UVS11 and the first-2 upper common voltage line UVS12 may be disposed on the first to fourth sub-pixel circuit units PCU1, PCU2, PCU3, and PCU4.

In one or more embodiments, seven second upper common voltage lines UVS2 may be arranged per four pixels PX. For example, the second-1 to second-7 upper common voltage lines UVS21, UVS22, UVS23, UVS24, UVS25, UVS26, and UVS27 may be disposed on the first to fourth sub-pixel circuit units PCU1, PCU2, PCU3, and PCU4.

As a result, referring to FIGS. 13A to 14C, a display apparatus according to one or more embodiments may efficiently perform a defect inspection and a repair process of a sub-pixel circuit because the driving voltage line PL (refer to FIG. 4) has a double-layered structure of the lower driving voltage line LPL and the upper driving voltage line UPL. In general, to reduce electrical interference, an upper portion of the data line DL (refer to FIG. 10) may be shielded by disposing a constant voltage line on the data line DL (refer to FIG. 10). When the data line DL (refer to FIG. 10) is shielded by a constant voltage line, parasitic capacitance may be reduced. However, when conducting a full contact array (FCA) inspection to inspect for defects in transistors within a sub-pixel circuit, the inspection may only be performed when all voltages required for an operation of the sub-pixel circuit are supplied. This creates a problem as the inspection can only take place after an uppermost conductive layer had been formed. In addition, when the inspection process and repair process are performed after the formation of an additional conductive layer over the data line DL (refer to FIG. 10), there is another issue of making the inspection and repair processes on a lower layer difficult due to the uppermost conductive layer obstructing access.

Accordingly, a comparative example in the related art arranges a plurality of inspection lines IW for a sub-pixel circuit inspection process in the peripheral area PA. First, referring to the comparative example of FIG. 15A, the peripheral area PA may contain a plurality of stages ST included in a gate driving circuit. In addition, a gate connection line SCL, which is configured to receive a gate signal from an n-th stage ST(n) or an n+1-th stage ST(n+1) and transmit the gate signal to the display area DA, may be arranged in the peripheral area PA. The gate connection line SCL may be configured in multiples and may include first to fourth gate connection lines SCL1, SCL2, SCL3, and SCL4, as shown in FIG. 15A. The first to fourth gate connection lines SCL1, SCL2, SCL3, and SCL4 may each be electrically connected to the gate line SL or emission control line EL of FIG. 2.

In this configuration, a plurality of inspection lines IW may be arranged between the stage ST and the display area DA. The plurality of inspection lines IW may be connected to a power supply to receive power or voltage required for inspection. The plurality of inspection lines IW may then transmit the received voltage through the voltage lines arranged in the display area DA and an inspection connection line ICL. For example, a first inspection line IW1 may receive a driving voltage and transmit the driving voltage to a voltage line of the display area DA through a first inspection connection line ICL1, and a second inspection line IW2 may receive an initialization voltage and transmit the initialization voltage to a voltage line of the display area DA through a second inspection connection line ICL2. Alternatively, a third inspection line IW3 may receive a reference voltage and transmit the reference voltage to a voltage line of the display area DA through a third inspection connection line ICL3.

With the arrangement of the inspection lines IW and the inspection connection line ICL described above, voltages required for the display area DA can be supplied even before an uppermost conductive layer is formed, and thus, an inspection to determine whether a sub-pixel circuit is operating normally, such as an FCA inspection, may be performed. However, in the case of the comparative example as in FIG. 15A, as the plurality of inspection lines IW and a plurality of inspection connection lines ICL are arranged in the peripheral area PA, there was a problem that a dead space where pixels are not arranged widened.

Conversely, a display apparatus according to one or more embodiments may perform an FCA inspection even after forming only the third conductive layer 1600, without arranging the inspection lines IW and the inspection connection line ICL, because the driving voltage line PL (refer to FIG. 4) has a double-layered structure of the lower driving voltage line LPL and the upper driving voltage line UPL. That is, the display apparatus 1 may perform an FCA inspection even after forming only the third conductive layer 1600 because the third conductive layer 1600 already includes the vertical reference voltage line VVRL, the vertical initialization voltage line VVAL, and the lower driving voltage line LPL, and thus, driving of a sub-pixel circuit is possible. The display apparatus in this state is in a state before the fourth conductive layer 1700 that shields some of the lines of the third conductive layer 1600 is formed, the repair rate may be efficiently increased even when a repair process is performed after inspection.

In addition, referring to FIG. 15B, a display apparatus according to one or more embodiments may not require an arrangement of the inspection line IW and the inspection connection line ICL, and thus, the area of the peripheral area PA may be reduced. For example, in the case of the comparative example as in FIG. 15A, a distance d1 between the stage ST and the display area DA may be greater than a distance d1' between the stage ST and the display area DA in one or more embodiments of the disclosure as in FIG. 15B, due to a width d2 of the plurality of inspection lines IW. As a result, the display apparatus according to one or more embodiments may simultaneously achieve the effects of increasing the efficiency of an inspection process and a repair process and reducing the area of the peripheral area PA by disposing the lower driving voltage line LPL on the third conductive layer 1600.

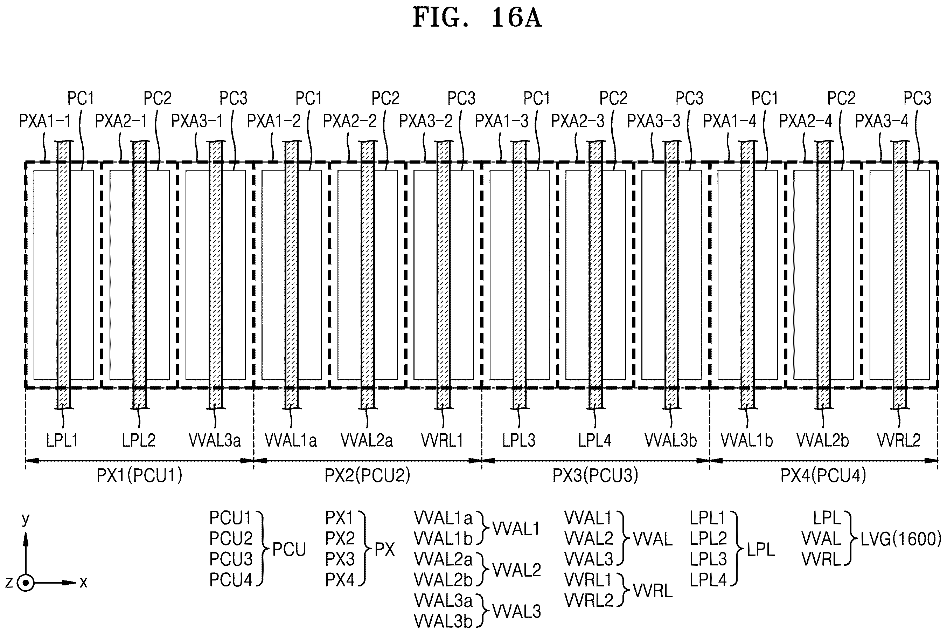

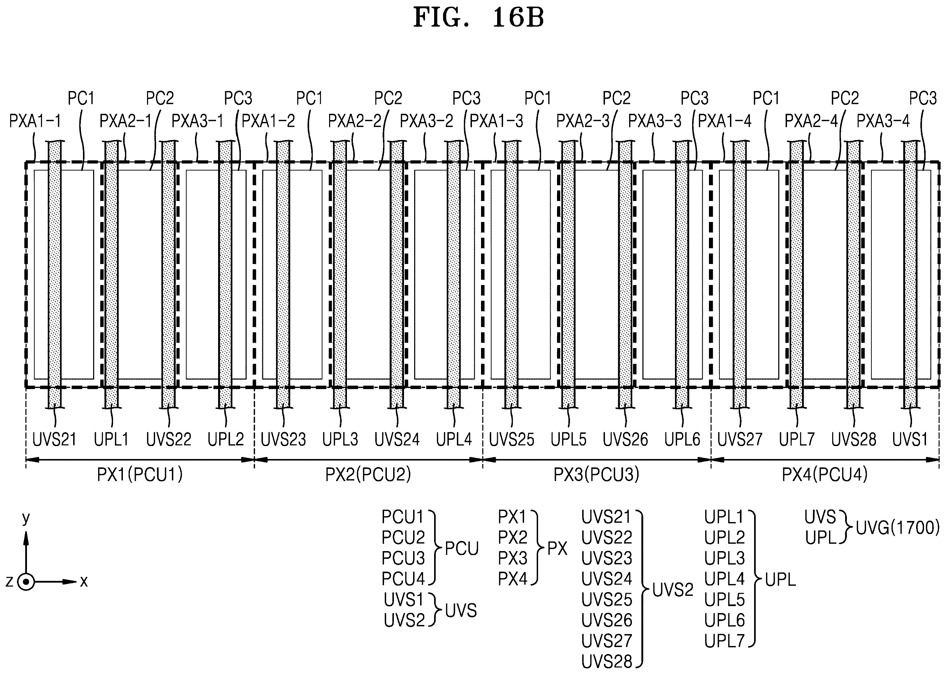

FIGS. 16A and 16B are schematic conceptual diagrams of arrangements of a plurality of voltage lines of a display apparatus according to another embodiment. Referring to FIGS. 16A and 16B, except for some voltage lines, other features are the same as described in FIGS. 4 to 14C. Among the components of FIGS. 16A and 16B, the same reference numerals are replaced with those described above with reference to FIGS. 4 to 14C, and the differences are mainly described below.

First, referring to FIG. 16A, the third conductive layer 1600 may include the lower voltage line group LVG including a plurality of voltage lines. The lower voltage line group LVG may include the lower driving voltage line LPL, the vertical initialization voltage line VVAL, and the vertical reference voltage line VVRL. At this time, the vertical reference voltage line VVRL may include a first vertical reference voltage line VVRL1 and a second vertical reference voltage line VVRL2.

In one or more embodiments, in the case of the third conductive layer 1600, three vertical voltage lines may be disposed on one sub-pixel circuit unit PCU. For example, the first lower driving voltage line LPL1, the second lower driving voltage line LPL2, and the third-1 vertical initialization voltage line VVAL3a may be disposed on the first sub-pixel circuit unit PCU1. The first-1 vertical initialization voltage line VVAL1a, the second-1 vertical initialization voltage line VVAL2a, and the first vertical reference voltage line VVRL1 may be disposed on the second sub-pixel circuit unit PCU2. The third lower driving voltage line LPL3, the fourth lower driving voltage line LPL4, and the third-2 vertical initialization voltage line VVAL3b may be disposed on the third sub-pixel circuit unit PCU3. The first-2 vertical initialization voltage line VVAL1b, the second-2 vertical initialization voltage line VVAL2b, and the second vertical reference voltage line VVRL2 may be disposed on the fourth sub-pixel circuit unit PCU4.

In one or more embodiments, the vertical reference voltage line VVRL may be arranged per two pixels PX. For example, as shown in FIG. 16A, the first vertical reference voltage line VVRL1 may be disposed on the first sub-pixel circuit unit PCU1 and the second sub-pixel circuit unit PCU2, and the second vertical reference voltage line VVRL2 may be disposed on the third sub-pixel circuit unit PCU3 and the fourth sub-pixel circuit unit PCU4.

Next, referring to FIG. 16B, the fourth conductive layer 1700 may include the upper voltage line group UVG including a plurality of voltage lines. The upper voltage line group UVG may include the upper driving voltage line UPL and the upper common voltage line UVS. The upper common voltage line UVS may include the first upper common voltage line UVS1 configured to transmit a common voltage to the opposite electrode 330 (refer to FIG. 12) through the auxiliary electrode AE (refer to FIG. 14C) within the display area DA (refer to FIG. 2), and the second upper common voltage line UVS2 configured to transmit a common voltage to the opposite electrode 330 (refer to FIG. 12) within the peripheral area PA (refer to FIG. 2).

In one or more embodiments, the first upper common voltage line UVS1 may be arranged per four pixels PX. For example, as shown in FIG. 16B, the first upper common voltage line UVS1 may be disposed on first to fourth sub-pixel circuit units PCU1, PCU2, PCU3, and PCU4.

In one or more embodiments, two second upper common voltage lines UVS2 may be arranged per one pixel PX. For example, as shown in FIG. 16B, the second-1 upper common voltage line UVS21 and the second-2 upper common voltage line UVS22 may be disposed on the first sub-pixel circuit unit PCU1, the second-3 upper common voltage line UVS23 and the second-4 upper common voltage line UVS24 may be disposed on the second sub-pixel circuit unit PCU2, the second-5 upper common voltage line UVS25 and the second-6 upper common voltage line UVS26 may be disposed on the third sub-pixel circuit unit PCU3, and the second-7 upper common voltage line UVS27 and the second-8 upper common voltage line UVS28 may be disposed on the fourth sub-pixel circuit unit PCU4.

Even when a display apparatus according to one or more embodiments includes the voltage line arrangement as described above, the display apparatus may simultaneously achieve the effects of increasing the efficiency of an inspection process and a repair process and reducing the area of the peripheral area PA as the driving voltage line PL (refer to FIG. 4) has a double-layered structure of the lower driving voltage line LPL and the upper driving voltage line UPL.

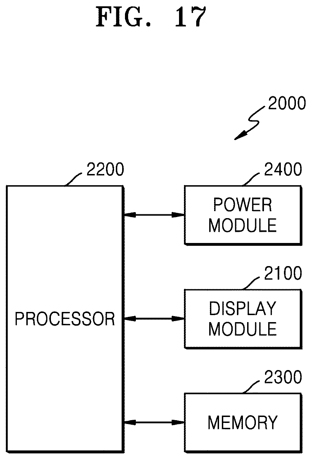

FIG. 17 is a block diagram of an electronic apparatus according to one or more embodiments.

Referring to FIG. 17, an electronic apparatus 2000 according to one or more embodiments may include a display module 2100, a processor 2200, a memory 2300, and a power module 2400.

The electronic apparatus 2000 may output various pieces of information through the display module 2100 within an operating system.

The processor 2200 may include at least one of a central processing unit (CPU), an application processor (AP), a graphics processing unit (GPU), a communication processor (CP), an image signal processor (ISP), and a controller. In one or more embodiments, the processor 2200 may be divided into two or more to be provided from a functional or structural perspective. For example, the processor 2200 may include a main processor in a form of a first drive chip including a central processing unit, and an auxiliary processor in a form of a second drive chip including a controller that receives an image signal from the main processor and processes the image signal to match interface specifications of the display module 2100.

The memory 2300 may include at least one of non-volatile memory and volatile memory. Data information necessary for an operation of the processor 2200 or the display module 2100 may be stored in the memory 2300. When the processor 2200 executes an application stored in the memory 2300, an image data signal and/or input control signal may be transmitted to the display module 2100, and the display module 2100 may process the received signal and output image information through a display screen.

The power module 2400 may include the power supply module, such as a power adapter or a battery device, and the power conversion module that generates power necessary for an operation of the electronic apparatus 2000 by converting power supplied by the power supply module. Power conversion by the power conversion module may include direct current (DC)-DC conversion, alternating current (AC)-DC conversion, and DC-AC conversion, but is not limited thereto.

At least one of the configurations of the electronic apparatus 2000 described above may be included in the display apparatus according to the embodiments described above. In addition, some of the individual modules functionally included within a module may be included in the display apparatus, and the others may also be provided separately from the display apparatus. For example, the display apparatus may include the display module 2100 and an auxiliary processor of the processor 2200, and a main processor of the processor 2200, the memory 2300, and the power module 2400 may be provided in the form of other devices within the electronic apparatus 2000 instead of the display apparatus. As another example, the power module 2400 may be provided within the display apparatus and may also supply power to the processor 2200 and the memory 2300 provided within the electronic apparatus 2000 instead of the display apparatus, but the disclosure is not limited thereto.

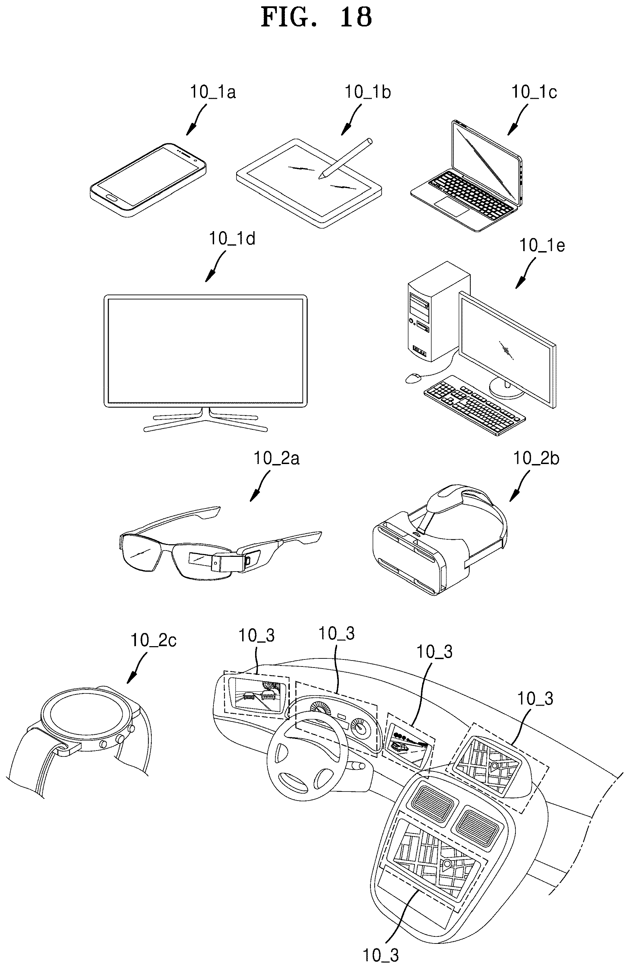

FIG. 18 shows schematic diagrams of electronic apparatuses according to various embodiments.

A display apparatus according to embodiments is an apparatus that displays moving images or still images, and may be applied to various electronic apparatuses. Referring to FIG. 18, various electronic apparatuses to which display apparatuses according to embodiments are applied may not only include electronic apparatuses for image display, such as a smartphone 10_1a, a tablet personal computer (PC) 10_1b, a laptop 10_1c, a television (TV) 10_1d, a desk monitor 10_1 e, but may also include wearable electronic apparatuses including display modules, such as smart glasses 10_2a, a head-mounted display 10_2b, a smart watch 10_2c, or the like, and electronic apparatuses 10_3 for a vehicle including a display module, such as a dashboard of a vehicle, a center fascia, a center information display (CID) disposed on a dashboard, a rear mirror display, or the like. The electronic apparatus 2000 according to embodiments is not limited to the devices described above.

The electronic apparatus of FIG. 18 may include the configurations illustrated in FIG. 17. For example, the smartphone 10_1a may include the display module 2100, the processor 2200, the memory 2300, and the power module 2400, which are shown in FIG. 17. The smartphone 10_1a may further include a communication module and a battery device. Power provided by the battery device may be converted through the power module 2400 to be provided to the processor 2200, the memory 2300, and the display module 2100. In one or more embodiments, a display apparatus applied to the smartphone 10_1a may include the display module 2100 and may further include the power module 2400. The processor 2200 and the memory 2300 may be provided in the form of chips mounted on a motherboard, which is an external device, but are not limited thereto.

According to some embodiments, a display apparatus providing high-quality images and an electronic apparatus may be provided. The effects described above are examples, and effects of the disclosure are not limited thereto.

It should be understood that embodiments described herein should be considered in a descriptive sense only and not for purposes of limitation. Descriptions of features or aspects within each embodiment should typically be considered as available for other similar features or aspects in other embodiments. While one or more embodiments have been described with reference to the figures, it will be understood by those of ordinary skill in the art that various changes in form and details may be made therein without departing from the scope as defined by the following claims.

## Claims

1. A display apparatus (1) comprising:
a first sub-pixel circuit unit (PCU1) comprising a first sub-pixel circuit (PC1), a second sub-pixel circuit (PC2), and a third sub-pixel circuit (PC3) that are arranged in a first direction;
a plurality of light-emitting diodes (LED) electrically connected to the first sub-pixel circuit (PC1), the second sub-pixel circuit (PC2), and the third sub-pixel circuit (PC3), respectively; and
a driving voltage line (PL) electrically connected to at least one of the first sub-pixel circuit (PC1), the second sub-pixel circuit (PC2), or the third sub-pixel circuit (PC3) to transmit a driving voltage (ELVDD),
wherein the driving voltage line (PL) comprises:
a lower driving voltage line (LPL) extending in a second direction crossing the first direction; and
an upper driving voltage line (UPL) on the lower driving voltage line in a thickness direction of the display apparatus (1), the upper driving voltage line (UPL) being electrically connected to the lower driving voltage line (LPL), and extending in the second direction.

2. The display apparatus of claim 1, further comprising a common voltage line (VSL) electrically connected to at least one of the plurality of light-emitting diodes to transmit a common voltage (ELVSS),
wherein the common voltage line (VSL) comprises:
a lower common voltage line (LVS) extending in the second direction; and
an upper common voltage line (UVS) on the lower common voltage line in the thickness direction of the display apparatus (1), the upper common voltage line (UVS) being electrically connected to the lower common voltage line (LVS), and extending in the second direction,
optionally wherein the lower driving voltage line (LPL) and the lower common voltage line (LVS) are on a same layer, and
the upper driving voltage line (UPL) and the upper common voltage line (UVS) are disposed on another same layer.

3. The display apparatus of any preceding claim, further comprising a data line (DL) electrically connected to at least one of the first sub-pixel circuit (PC1), the second sub-pixel circuit (PC2), or the third sub-pixel circuit (PC3) to transmit a data signal (DATA), and extending in the second direction,
wherein the data line (DL) is on a same layer as the lower driving voltage line (LPL),
optionally wherein each of the first sub-pixel circuit (PC1), the second sub-pixel circuit (PC2), and the third sub-pixel circuit (PC3) comprises:
a first transistor (T1) electrically connected between one of the plurality of light-emitting diodes (LED) and the driving voltage line (PL);
a first node electrode (N1, 1530) connected to a gate electrode of the first transistor (T1); and
a second transistor (T2) connected between the data line (DL) and the first node electrode (N1, 1530), and
wherein the lower driving voltage line (LPL) and the data line (DL) are on the first node electrode (N1, 1530) in the thickness direction of the display apparatus (1).

4. The display apparatus of any preceding claim, further comprising a second sub-pixel circuit unit (PCU2), a third sub-pixel circuit unit (PCU3), and a fourth sub-pixel circuit unit (PCU4), which are arranged adjacent to the first sub-pixel circuit unit (PCU1) in the first direction and are sequentially arranged in the first direction;
a lower voltage line group (LVG) comprising a plurality of lower voltage lines on the first to fourth sub-pixel circuit units and extending in the second direction; and
an upper voltage line group (UVG) comprising a plurality of upper voltage lines on the plurality of lower voltage lines and extending in the second direction,
wherein the lower voltage line group (LVG) and the upper voltage line group (UVG) are repeatedly arranged within a display area (DA) of the display apparatus.

5. The display apparatus of claim 4, wherein the lower voltage line group (LVG) comprises:
the lower driving voltage line (LPL);
a lower common voltage line (LVS) electrically connected to one of the plurality of light-emitting diodes (LED) to transmit a common voltage (ELVSS) and extending in the second direction;
a reference voltage line (VRL) electrically connected to at least one of the first sub-pixel circuit (PC1), the second sub-pixel circuit (PC2), or the third sub-pixel circuit (PC3) to transmit a reference voltage (VREF) and extending in the second direction; and
an initialization voltage line (VAL) electrically connected to at least one of the first sub-pixel circuit (PC1), the second sub-pixel circuit (PC2), or the third sub-pixel circuit (PC3) to transmit an initialization voltage (Vaint) and extending in the second direction,
optionally wherein two lower driving voltage lines (LPL) are on two sub-pixel circuit units among the first sub-pixel circuit unit (PCU1), the second sub-pixel circuit unit (PCU2), the third sub-pixel circuit unit (PCU3), and the fourth sub-pixel circuit unit (PCU4).

6. The display apparatus of claim 5, wherein the initialization voltage line (VPL) comprises:
a first initialization voltage line (VAL1) configured to transmit the initialization voltage (Vaint) to the first sub-pixel circuit (PC1);
a second initialization voltage line (VAL2) configured to transmit the initialization voltage (Vaint) to the second sub-pixel circuit (PC2); and
a third initialization voltage line (VAL3) configured to transmit the initialization voltage to the third sub-pixel circuit (PC3), and
wherein one first initialization voltage line (VAL1), one second initialization voltage line (VAL2), and one third initialization voltage line (VAL3) are on two sub-pixel circuit units among the first sub-pixel circuit unit (PCU1), the second sub-pixel circuit unit (PCU2), the third sub-pixel circuit unit (PCU3), and the fourth sub-pixel circuit unit (PCU4).

7. The display apparatus of claim 5 or claim 6, wherein one reference voltage line (VRL) is on the first sub-pixel circuit unit (PCU1), the second sub-pixel circuit unit (PCU2), the third sub-pixel circuit unit (PCU3), and the fourth sub-pixel circuit unit (PCU4), and
wherein one lower common voltage line (LVS) is on the first sub-pixel circuit unit (PCU1), the second sub-pixel circuit unit (PCU2), the third sub-pixel circuit unit (PCU3), and the fourth sub-pixel circuit unit (PCU4).

8. The display apparatus (1) of any one of claims 4 - 7, wherein each of the plurality of light-emitting diodes (LED) comprises a pixel electrode (310), an opposite electrode (330), and an intermediate layer (320) between the pixel electrode (310) and the opposite electrode (330), and
the upper voltage line group (UVG) comprises:
the upper driving voltage line (UPL); and
an upper common voltage line (UVS) electrically connected to the opposite electrode to transmit a common voltage to the opposite electrode and extending in the second direction.

9. The display apparatus (1) of claim 8, further comprising an auxiliary electrode (AE) on a same layer as the pixel electrode (310), the auxiliary electrode (AE) being spaced apart from the pixel electrode (310) and in contact with the opposite electrode (330),
wherein the upper common voltage line (UVS) comprises:
a first upper common voltage line (UVS1) in contact with the auxiliary electrode (AE) within the display area (DA) to transmit the common voltage (ELVSS) to the opposite electrode (330); and
a second upper common voltage line (UVS2) configured to transmit the common voltage (ELVSS) to the opposite electrode (330) within a peripheral area (PA) that surrounds the display area (DA),
optionally wherein seven upper driving voltage lines (UPL1 - UPL7) and seven second upper common voltage lines (UVS21 - UVS27) are on the first sub-pixel circuit unit, the second sub-pixel circuit unit, the third sub-pixel circuit unit, and the fourth sub-pixel circuit unit, and
two first upper common voltage lines (UVS11, UVS12) are on the first sub-pixel circuit unit (PCU1), the second sub-pixel circuit unit (PCU2), the third sub-pixel circuit unit (PCU3), and the fourth sub-pixel circuit unit (PCU4).

10. The display apparatus (1) of any preceding claim, wherein at least a portion of the upper driving voltage line (UPL) has a mesh-shaped structure, and
wherein the upper driving voltage line comprises:
a first vertical portion (UPm1) extending in the second direction;
a second vertical portion (UPm2) extending in the second direction; and
a first horizontal portion (UPh1) extending in the first direction and connecting the first vertical portion (UPm1) to the second vertical portion (UPm2).

11. A display apparatus (1) comprising:
a substrate (100);
a first sub-pixel circuit (PC1) on the substrate (100);
a first light-emitting diode (LED) electrically connected to the first sub-pixel circuit (PC1);
a plurality of voltage lines comprising a driving voltage line (PL), an initialization voltage line (VAL), and a reference voltage line (VRL), which are electrically connected to the first sub-pixel circuit (PC1); and
a data line (DL) electrically connected to the first sub-pixel circuit (PC1) to transmit a data signal (DATA),
wherein the first sub-pixel circuit (PC1) comprises:
a driving transistor (T1) connected between the driving voltage line (PL) and the first light-emitting diode (LED);
a first node electrode (N1, 1530) connected to a gate electrode of the driving transistor (T1);
a switching transistor (T2) connected between the data line (DL) and the first node electrode (N1, 1530);
a first initialization transistor (T3) connected between the reference voltage line (VRL) and the first node electrode (N1, 1530); and
a second initialization transistor (T4) connected between the initialization voltage line (VAL) and the first light-emitting diode (LED),
wherein a pixel circuit layer (PCL) comprising the first sub-pixel circuit (PC1) comprises:
a semiconductor layer (1300) comprising a semiconductor pattern (1320) of the driving transistor;
a first conductive layer (1400) on the semiconductor layer (1300) and comprising the gate electrode (G1) of the driving transistor (T1);
a second conductive layer (1500) on the first conductive layer (1400) and comprising the first node electrode (N1, 1530); and
a third conductive layer (1600) on the second conductive layer (1500), the third conductive layer (1600) comprising a lower driving voltage line comprised in the driving voltage line (LPL), the data line (DL), the initialization voltage line (VAL), and the reference voltage line (VRL).

12. The display apparatus (1) of claim 11, wherein the driving voltage line (PL) further comprises an upper driving voltage line (UPL) on the lower driving voltage line (LPL), and
the pixel circuit layer further comprises a fourth conductive layer (1700) on the third conductive layer (1600) and comprising the upper driving voltage line (UPL).

13. The display apparatus of claim 12, further comprising a common voltage line (VSL) electrically connected to the first light-emitting diode (LED) to transmit a common voltage (ELVSS),
wherein the common voltage line (VSL) comprises:
a lower common voltage line (LVS) included in the third conductive layer (1600), the lower common voltage line (LVS) being on a same layer as the lower driving voltage line (LPL); and
an upper common voltage line (UVS) included in the fourth conductive layer (1700), the upper common voltage line (UVS) being on another same layer as the upper driving voltage line (UPL),
optionally wherein the data line (DL) overlaps the upper common voltage line (UVS) when viewed in a thickness direction of the display apparatus (1).

14. The display apparatus of any one of claims 11 - 13, wherein the first sub-pixel circuit (PC1) further comprises:
an emission control transistor (T6) connected between the driving transistor (T1) and the first light-emitting diode (LED);
a second node electrode (N2, 1540) connecting the semiconductor pattern (1320) of the driving transistor to a semiconductor pattern (1330) of the emission control transistor (T6);
a storage capacitor (Cst) connected between the first node electrode (N1, 1530) and the second node electrode (N2, 1540); and
a hold capacitor (Ch) connected between the driving voltage line (PL) and the second node electrode (N2, 1540), and
wherein the second conductive layer (1500) further comprises the second node electrode (N2, 1540).

15. An electronic apparatus (2000) comprising:
a processor (2200); and
the display apparatus of any preceding claim, the display apparatus being configured to be controlled by the processor (2200).
